# EUROPEAN PATENT SPECIFICATION

(11) **EP 2 290 700 B1**
(45) Date of publication and mention of the grant of the patent: **05.03.2014**
(21) Application number: 09758384.3
(22) Date of filing: 04.06.2009
(51) Int. Cl.: H01L 31/04, C23C 16/505, H01L 21/205, C23C 16/509, C23C 16/54

(54) **APPARATUS FOR MANUFACTURING THIN FILM SOLAR CELL**
VORRICHTUNG ZUR HERSTELLUNG EINER DÜNNFILMSOLARZELLE
APPAREIL DE FABRICATION DE CELLULE SOLAIRE À COUCHE MINCE

(30) Priority: 06.06.2008 JP 2008149934
(43) Date of publication of application: 02.03.2011
(73) Proprietor: Ulvac, Inc., Chigasaki-shi Kanagawa 253-8543 (JP)
(72) Inventor: SHIMIZU Yasuo, Chigasaki-shi, Kanagawa 253-8543 (JP); OGATA Hideyuki, Chigasaki-shi, Kanagawa 253-8543 (JP); MATSUMOTO Koichi, Chigasaki-shi, Kanagawa 253-8543 (JP); NOGUCHI Takafumi, Chigasaki-shi, Kanagawa 253-8543 (JP); WAKAMORI Jouji, Chigasaki-shi, Kanagawa 253-8543 (JP); OKAYAMA Satohiro, Chigasaki-shi, Kanagawa 253-8543 (JP); MORIOKA Yawara, Chigasaki-shi, Kanagawa 253-8543 (JP); SUGIYAMA Noriyasu, Chigasaki-shi, Kanagawa 253-8543 (JP); SHIGETA Takashi, Chigasaki-shi, Kanagawa 253-8543 (JP); KURIHARA Hiroyuki, Chigasaki-shi, Kanagawa 253-8543 (JP)
(74) Representative: Eisenführ Speiser
(86) International application number: PCT/JP2009/060247
(87) International publication number: WO 2009/148117

(56) References cited:
- JP-A- 11 330 520
- JP-A- 2002 359 203
- JP-A- 2004 335 601
- JP-A- 2005 158 982
- JP-A- 2007 027 469
- JP-T- 2002 531 695

## Description

### Technical Field

. The present invention relates to an apparatus for manufacturing a thin-film solar cell.

### Background Art

Although most current solar cells are of a single crystal Si type and a polycrystal Si type, there are growing concerns about material shortages or the like of Si. Thus, demand has recently been increasing for thin-film solar cells formed with a thin-film Si-layer in which the manufacturing costs are low and the risk of material shortages is low. Moreover, in addition to a conventional thin-film solar cells having only an a-Si (amorphous silicon) layer, demand for tandem-type thin-film solar cells aiming at improvements in photoelectric conversion efficiency by laminating an a-Si-layer and a µc-Si (microcrystalline silicon) layer has recently been increasing.

A plasma-CVD apparatus is often used for film-forming a thin-film Si-layer (semiconductor layer) of the thin-film solar cells. As this type of plasma-CVD apparatus, a single-wafer-type PE-CVD (plasma CVD) apparatus, an in-line type PE-CVD apparatus, a batch-type PE-CVD apparatus, and the like exist.

When the conversion efficiency as a thin-film solar cell is taken into consideration, the µc-Si-layer of the above tandem-type solar cell needs to be film-formed with a film thickness (about 1.5 µm) of about five times larger than the a-Si-layer. Additionally, since the µc-Si-layer needs to be uniformly formed of a good microcrystal film, there is also a limit to increasing a film formation rate. Accordingly, in order to compensate for this, productivity is required to be improved by virtue of an increase in the number of batch processings or the like. That is, an apparatus which can realize higher throughput at a low film formation rate is needed.

Additionally, as a CVD apparatus which aims at improvements in productivity and is able to form a film with high precision even on a substrate to be enlarged, there is a vertical CVD apparatus which performs film forming in a state where the film formation face of the substrate is arranged so as to be substantially parallel to the direction of gravitational force. Some of the vertical CVD apparatuses have a carrier (conveying part) in which a pair of supporting walls (holders) for supporting a substrate is vertically provided. The respective supporting walls are arranged so as to be substantially parallel to each other. The carrier moves along the planar direction thereof in a state where the substrate is supported by the respective supporting walls, and conveys the substrate into the film forming chamber. The film forming chamber is provided with a heater for heating each substrate. This heater is disposed between the pair of conveyed substrates. Additionally, high-frequency electrodes (cathodes) are respectively disposed on both side walls of the film forming chamber at the inner surface thereof. By supplying electric power to the high-frequency electrodes, a film forming gas supplied to the film forming chamber is turned into plasma (for example, refer to Patent Document 1).

### Citation List

### [Patent Document]

[Patent Document 1] Japanese Patent Application, First Publication No. 2002-270600

JP 2004 - 335 601 A (EP 1 662 192 A) shows a substrate transfer device for a thin film deposition apparatus where each of a plurality of substrates faces an electrode.

### Summary of the Invention

### Problems to be Solved by the Invention

When a thin-film Si-layer is film-formed on a substrate, it is necessary to set the gap between the substrate and the high-frequency electrode to an arbitrary gap (for example, 5 mm) within a range of about 5 mm to 15 mm.

However, in the above-described conventional technique, a substrate is supported by the supporting wall vertically provided at the carrier, and the substrate is conveyed to the film forming chamber in this state. Thus, if clattering or the like of the carrier is taken into consideration, it is difficult to set the gap between the substrate and the high-frequency electrode to about 5 mm. If this gap becomes large, there is a possibility that the quality of the thin-film Si-layer may deteriorate.

Additionally, even if the gap between the substrate which has been conveyed to the film forming chamber by the carrier and the high-frequency electrode can be set to about 5 mm, this gap is minute when the size of the apparatus is taken into consideration. Therefore, it is difficult to make the substrate enter and exit from the film forming chamber. For this reason, in the conventional technique, there is also a case where a back plate used as the anode is conveyed integrally with the substrate. However, since an object to be conveyed becomes larger, a conveying mechanism becomes larger.

Thus, the present invention has been made in consideration of the above circumstances, and the object thereof is to provide an apparatus for manufacturing a thin-film solar cell which can facilitate entrance and exit of a substrate from the film forming chamber while improving the quality of a film to be formed, and can improve productivity.

### Means for Solving the Problem

The present invention has adopted the followings in order to solve the above problems and achieve the relevant object.
(1) An apparatus for manufacturing a thin film solar cell of the present invention includes: a film forming chamber in which a substrate is arranged so that the film formation face of the substrate is substantially parallel to the direction of gravitational force and a film is formed on the film formation face by a CVD method; an electrode unit including a cathode unit having shower plates to which voltages are to be applied arranged on both sides thereof, and a pair of anodes each of which is arranged to face a different one of the shower plates, at a separation distance therefrom; and a conveying part which supports the substrate and conveys the substrate to between the cathode unit and the anode facing the cathode unit. The electrode unit further includes a drive part which moves the anode in directions which make the anode approach or separate from the cathode unit. The separation distance is variable.

According to the apparatus for manufacturing a thin-film solar cell described in the above (1), the gap between the anode and the cathode unit can be set to be large when a substrate enters and exits the film forming chamber. Meanwhile, when a film is formed on the film formation face of a substrate, the gap between the anode and the cathode unit can be set to be small. As a result, the gap between the substrate and the cathode unit can be set to be small, specifically, for example, about 5 mm. For this reason, it is possible to facilitate entrance and exit of the substrate from the film forming chamber while improving the quality of a film to be formed, and it is possible to improve productivity.

Additionally, when the substrate enters and exits the film forming chamber, it is possible to prevent the substrate from contacting and being damaged by the anode or the cathode unit.
(2) The electrode unit includes a drive part which makes the anode approach and separate from the cathode.
   In the above (2), the cathode unit which is comparatively difficult to move is disposed between two substrates, that is, substantially at the center of the film forming chamber. Meanwhile, the anodes which are comparatively easy to move are disposed outside two substrates, that is, in the vicinity of the lateral surface of the film forming chamber. The separation distance between the substrate and the cathode unit is controlled by making the anode movable by the drive part. For this reason, as compared to a case where the cathode unit is moved, complication of the apparatus for manufacturing a thin-film solar cell can be suppressed, and the manufacturing costs of this apparatus can be reduced.
(3) The separation distance between the film formation face of the substrate and the cathode may be controlled as the anode moves while abutting the substrate when the anode approaches the cathode.
   In the above (3), when a substrate is conveyed, the substrate and the anode can be separated from each other, and the substrate can be conveyed without conveying the anode. Additionally, when a film is formed on the film formation face of the substrate, nothing can be interposed between the anode and the substrate. For this reason, heat exchange can be efficiently performed between the substrate and the anode.
(4) The cathode may be a shower plate which supplies a film forming gas to the film formation face of the substrate.
   In the above (4), it becomes unnecessary to separately provide the cathode and the shower plate, and it is possible to achieve simplification and lower cost of the apparatus for manufacturing a thin-film solar cell.
(5) The cathode unit may further include a cathode intermediate member made of an electrical conductor, and the pair of cathodes may be connected to the cathode intermediate member.
   In the above (5), it is possible to apply voltages of the same potential and phase without separately controlling the pair of cathodes. For this reason, the configuration of a voltage control device or the like can be simplified, and lower cost of the apparatus for manufacturing a thin-film solar cell can be achieved.
(6) The cathode unit may further include two gas supply passages, each of the gas supply passages may be connected to the corresponding cathodes, and the flow rate or kind of the film forming gas discharged from one of the cathodes may be controlled independently from the other cathode.
   In the above (6), the film forming gases discharged from the respective cathodes can be independently controlled according to the status of use of the apparatus for manufacturing a thin-film solar cell. Therefore, a difference can be prevented from appearing in the quality of films formed on the substrates arranged between the cathodes and the anodes. Additionally, it is also possible to form different films on the substrates arranged between the cathodes and the anodes, and the variation of the film forming method can be increased.
(7) A discharge duct through which the film forming gas is evacuated may be arranged on the outer peripheral surface of the cathode unit.
   In the above (7), the film forming gas (exhaust gas) can be evacuated from the whole periphery of the substrate. For this reason, it is possible to improve the evacuation efficiency.
   Additionally, for example, reactive by-products (powder) or the like generated when a film is formed on the film formation face of a substrate can be easily collected by performing evacuation using the discharge duct. In this case, it is possible to make reactive by-products (powder) adhere to and deposit on the inner wall of the discharge duct, thereby evacuating a comparatively clean film forming gas which does not include reactive by-products (powder).
(8) The conveying part may have a first holding piece which abuts the film formation face of the substrate, and a second holding piece which abuts the back surface of the substrate. The substrate may be held by the first holding piece and the second holding piece. When the anode approaches the cathode unit, the first holding piece may separate from the second holding piece. When the anode separates from the cathode unit, the first holding piece may approach the second holding piece.
   In the above (8), with the movement of the anode, the substrate can be easily approached or separated from the cathode unit.
(9) In the apparatus for manufacturing a thin film solar cell described in the above (1), a temperature control section for controlling the temperature of the substrate may be built in the anode.
   In the above (9), it is possible to efficiently control the temperature of the substrate. More specifically, not only a substrate can be efficiently heated, but also the anode can be used as a heat dissipation medium of the substrate, for example, if the substrate gets too warm with prolonged film forming processing work. For this reason, irrespective of the passage of time for film formation processing work, it is possible to keep the substrate constant at a desired temperature, and higher-quality film formation can be performed.

### Advantageous Effects of Invention

According to the apparatus for manufacturing a thin-film solar cell described in the above (1), the separation distance between the anode and the cathode can be controlled. Thus, the gap between the anode and the cathode unit can be set to be large when a substrate enters and exits the film forming chamber. Meanwhile, when a film is formed on the film formation face of a substrate, the gap between the anode and the cathode unit can be set to be small. As a result, the gap between the substrate and the cathode unit can be set to be small, specifically, for example, about 5 mm. For this reason, it is possible to facilitate entrance and exit of the substrate from the film forming chamber while improving the quality of a film to be formed, and it is possible to improve productivity.

### Brief Description of the Drawings

FIG 1 is a schematic sectional view showing an example of a thin-film solar cell manufactured by an apparatus for manufacturing a thin-film solar cell of the present invention.
FIG 2 is a schematic plan view of an apparatus for manufacturing a thin-film solar cell related to one embodiment of the present invention.
FIG 3A is a perspective view of a film forming chamber of the present embodiment.
FIG 3B is a perspective view when the film forming chamber is seen from a different angle.
FIG 3C is a side view of the film forming chamber.
FIG 4A is a perspective view of an electrode unit of the present embodiment.
FIG 4B is a perspective view when the electrode unit is seen from a different angle.
FIG 4C is a view showing a modification of the electrode unit, and is an exploded perspective view of a part of the electrode unit.
FIG 4D is a partial sectional view of a cathode unit and anode unit of the electrode unit of the present embodiment.
FIG 5A is a perspective view of a loading-ejecting chamber of the present embodiment.
FIG 5B is a perspective view when the loading-ejecting chamber is seen from a different angle.
FIG 6 is a schematic configuration of a push-pull mechanism of the present embodiment.
FIG 7A is a perspective view showing a schematic configuration of a substrate replacement chamber of the present embodiment.
FIG 7B is a front view in Fig. 7A.
FIG 8 is a perspective view of a substrate storage holder of the present embodiment.
FIG 9 is a perspective view of a carrier of the present embodiment.
FIG. 10 is an explanatory view (1) showing a process of a method for manufacturing a thin-film solar cell related to one embodiment of the present invention using the above apparatus for manufacturing a thin-film solar cell.
FIG 11 is an explanatory view (2) showing the subsequent process of the method for manufacturing a thin-film solar cell.
FIG 12 is an explanatory view (3) showing the subsequent process of the method for manufacturing a thin-film solar cell.
FIG 13 is an explanatory view (4) showing the subsequent process of the method for manufacturing a thin-film solar cell.
FIG 14 is an explanatory view (5) showing the subsequent process of the method for manufacturing a thin-film solar cell.
FIG 15A is an explanatory view showing the operation of the push-pull mechanism of the present embodiment.
FIG. 15B is an explanatory view showing the operation of the push-pull mechanism of the present embodiment.
FIG 16 is an explanatory view (6) showing the subsequent process of the method for manufacturing a thin-film solar cell using the above apparatus for manufacturing a thin-film solar cell.
FIG 17 is an explanatory view (7) showing the subsequent process of the method for manufacturing a thin-film solar cell.
FIG 18 is an explanatory view (8) showing the subsequent process of the method for manufacturing a thin-film solar cell, and is a schematic sectional view when a substrate is inserted into the electrode unit.
FIG 19 is an explanatory view (9) showing the subsequent process of the method for manufacturing a thin-film solar cell.
FIG 20 is an explanatory view (10) showing the subsequent process of the method for manufacturing a thin-film solar cell.
FIG 21 is an explanatory view (11) showing the subsequent process of the method for manufacturing a solar cell, and is a partial sectional view when a substrate is set on the electrode unit.
FIG 22 is an explanatory view (12) showing the subsequent process of the method for manufacturing a thin-film solar cell.
FIG 23 is an explanatory view (13) showing the subsequent process of the method for manufacturing a thin-film solar cell.
FIG 24 is an explanatory view (14) showing the subsequent process of the method for manufacturing a thin-film solar cell.
FIG 25 is an explanatory view (15) showing the subsequent process of the method for manufacturing a thin-film solar cell.

### Best Mode for Carrying Out the Invention

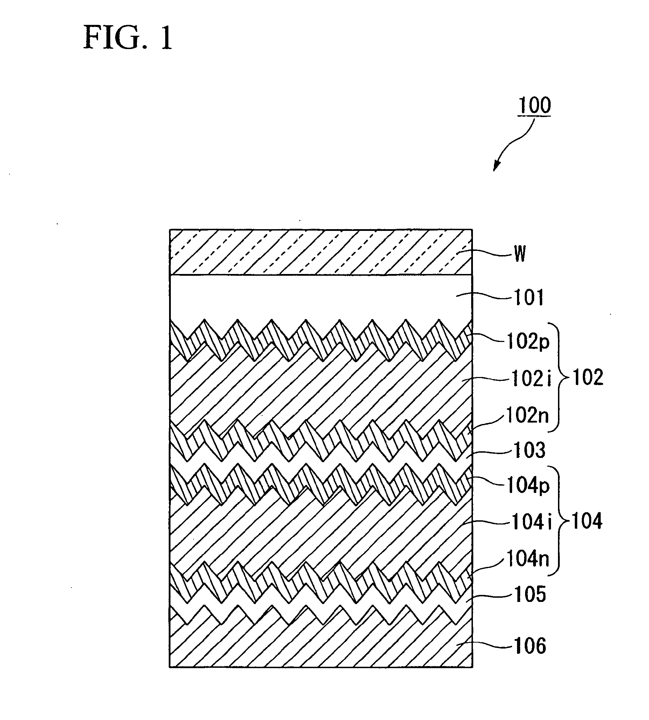

An apparatus for manufacturing a thin-film solar cell related to one embodiment of the present invention will be described with reference to FIGS. 1 to 25.

### (Thin-film Solar Cell)

FIG 1 is a sectional view schematically showing an example of a thin-film solar cell 100 manufactured by an apparatus for manufacturing a thin-film solar cell of the present invention. As shown in FIG 1, the thin-film solar cell 100 is configured such that a substrate W (for example, a glass substrate or the like) which constitutes the surface of the solar cell; a top electrode 101 made of a transparent conductive film provided on the substrate W; a top cell 102 made of amorphous silicon; an intermediate electrode 103 made of a transparent conductive film provided between the top cell 102 and a bottom cell 104 which will be described later; the bottom cell 104 made of microcrystalline silicon; a buffer layer 105 made of a transparent conductive film; and a back electrode 106 made of a metal film; are laminated. That is, the thin-film solar cell 100 is an amorphous silicon/microcrystalline silicon tandem-type solar cell. In the thin-film solar cell 100 of such tandem structure, power generation efficiency can be improved by absorbing short-wavelength light with the top cell 102 and absorbing long-wavelength light with the bottom cell 104.

The top cell 102 forms a three-layer structure of a p-layer (102p), i-layer (102i), and n-layer (102n), each of which is formed from amorphous silicon. The bottom cell 104 forms a three-layer structure of a p-layer (104p), i-layer (104i), and n-layer (104n), each of which is formed from microcrystalline silicon.

In the thin-film solar cell 100 having such a configuration, when an energy particle called a photon in sunlight strikes the i-layer, an electron and a positive hole (hole) are generated by a photovoltaic effect, the electron moves toward the n-layer and the positive hole moves toward the p-layer. Light energy can be converted into electrical energy by taking out the electron and positive hole generated by the photovoltaic effect from the top electrode 101 and the back electrode 106.

The intermediate electrode 103 is provided between the top cell 102 and the bottom cell 104, whereby a part of the light which passes through the top cell 102 and reaches the bottom cell 104 is reflected by the intermediate electrode 103 and enters the top cell 102 again. Therefore, the sensitivity characteristics of the cell improve, and the power generation efficiency improves.

Additionally, the sunlight which has entered from the substrate W side passes through the respective layers, and is then reflected by the back electrode 106. In order to improve the conversion efficiency of light energy, the thin-film solar cell 100 of the present embodiment adopts a textured structure aiming at a prismatic effect which extends the optical path of the sunlight which has entered the top electrode 101, and the confinement effect of light.

### (Apparatus for Manufacturing Thin-film Solar Cell)

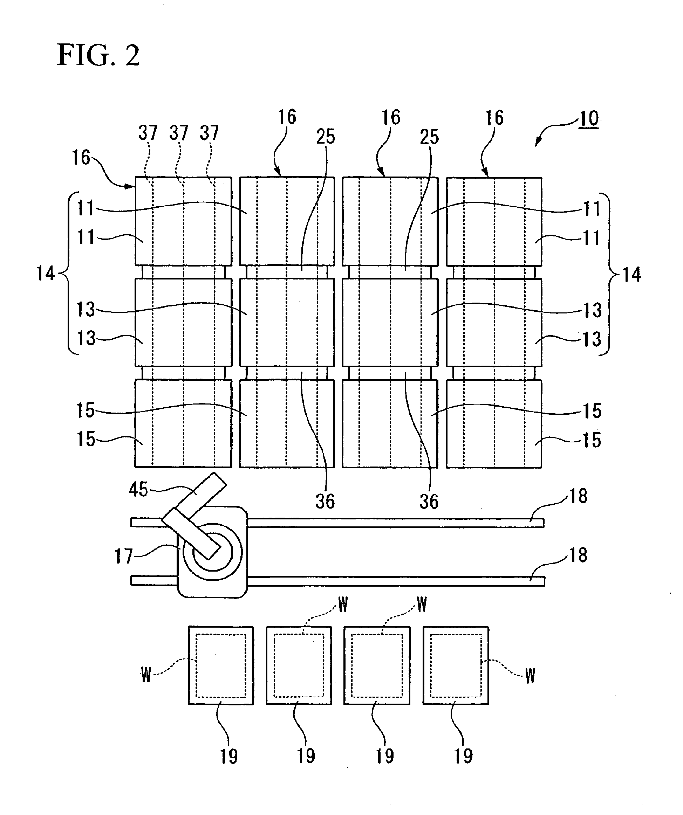

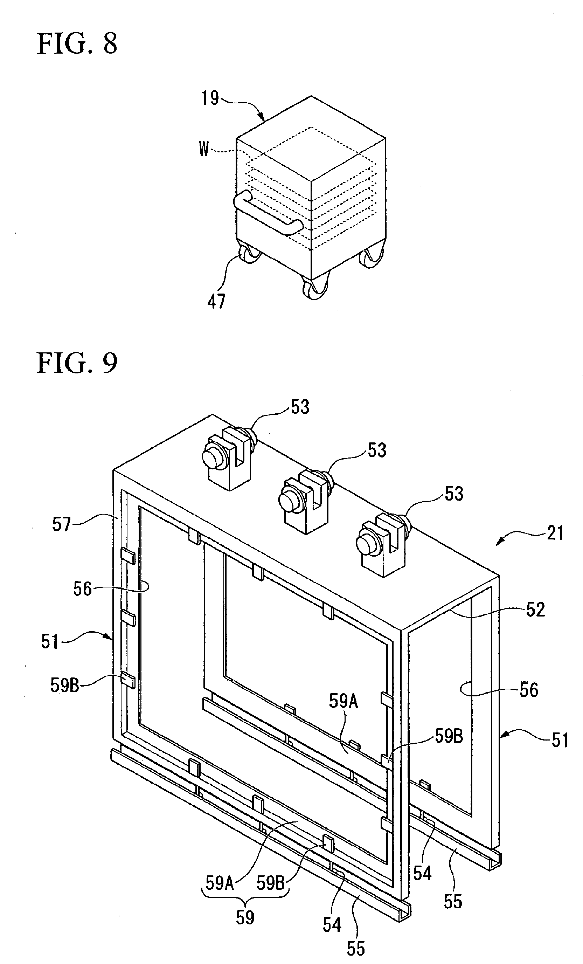

FIG. 2 is a schematic plan view of the apparatus for manufacturing a thin-film solar cell related to one embodiment of the present invention. As shown in FIG 2, the apparatus 10 for manufacturing a thin-film solar cell includes: film forming chambers 11 capable of simultaneously film-forming bottom cells 104 (semiconductor layers) made of microcrystalline silicon on a plurality of substrates W; loading-ejecting chambers 13 capable of simultaneously storing pre-processed substrates W1 (substrates W) carried into the film forming chamber 11 and post-processed substrates W2 (substrates W) carried out of the film forming chamber 11; a substrate replacement chamber 15 where the pre-processed substrates W1 and the post-processed substrates W2 are attached to and detached from a carrier 21 (conveying part: refer to FIG 9); a substrate replacement robot 17 for attaching the substrates W to and detaching the substrates W from the carrier 21, and substrate storage holders 19 which store the substrates W in order to convey the substrates to separate processing chambers. In the present embodiment, four substrate film formation lines 16 each including the film forming chamber 11, the loading-ejecting chamber 13, and the substrate replacement chamber 15 are provided. The substrate replacement robot 17 is adapted to be able to move on rails 18 laid on a floor surface. Thereby, transfer of the substrates W to all the substrate film formation lines 16 can be performed by one substrate replacement robot 17. Moreover, the film forming chamber 11 and the loading-ejecting chamber 13 are integrated together to constitute a substrate film formation module 14, and have sizes such that the module 14 can be loaded into an autotruck.

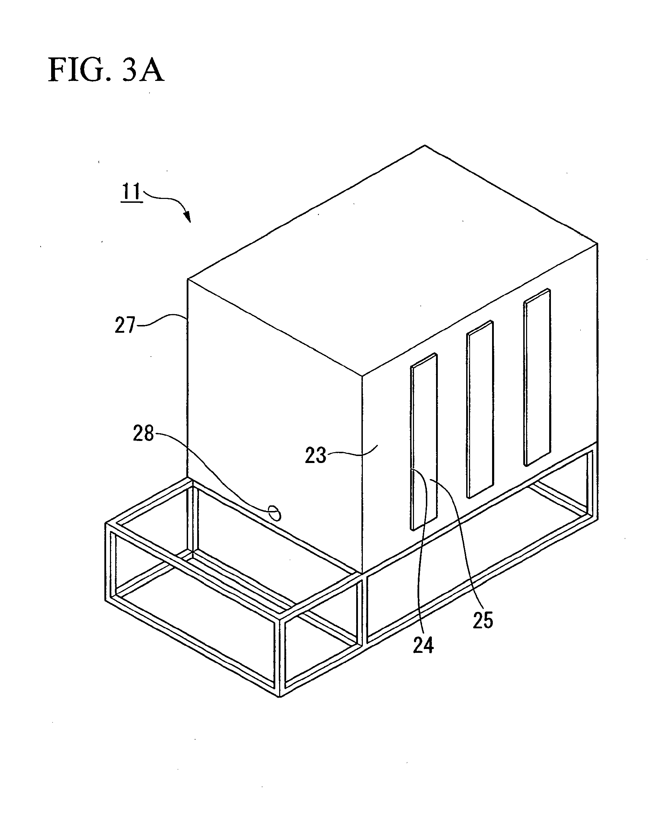

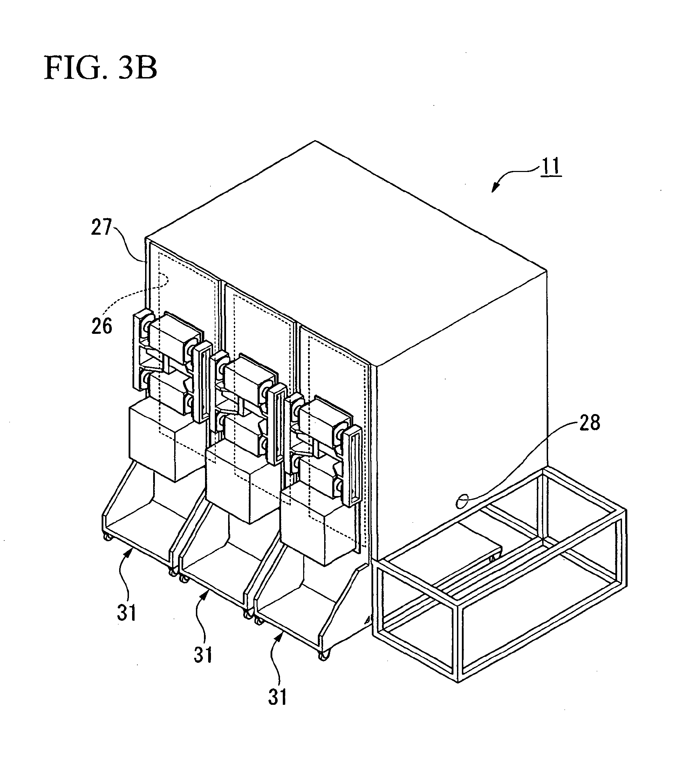

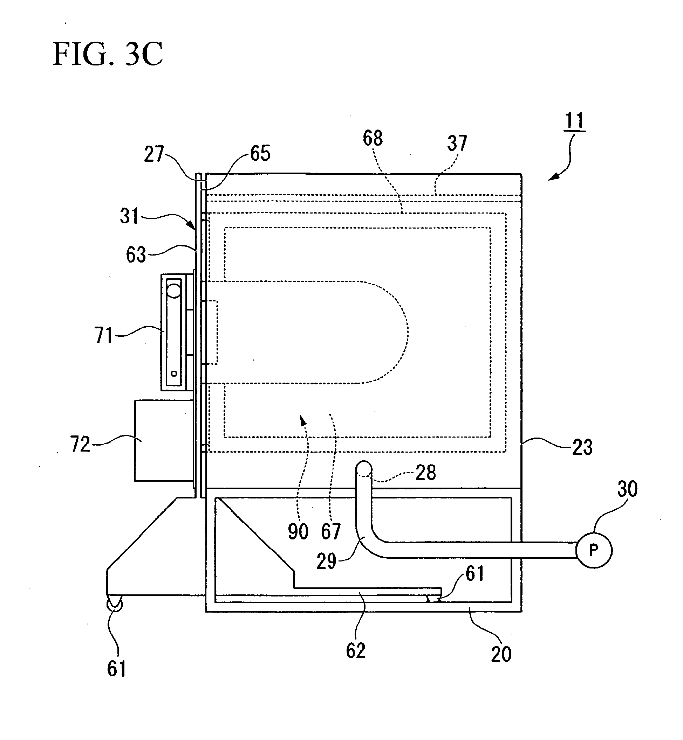

FIGS. 3A to 3C are schematic configuration views of the film forming chamber. FIG 3A is a perspective view, FIG 3B is a perspective view as seen from an angle different from FIG 3A, and FIG 3C is a side view.

As shown in these FIGS. 3A to 3C, the film forming chamber 11 is formed in the shape of a box. A first lateral surface 23 of the film forming chamber 11 connected to the loading-ejecting chamber 13 is formed with three carrier transfer inlet ports 24 which allow the carrier 21 on which the substrates W are mounted to pass therethrough. The carrier transfer inlet ports 24 are respectively provided with shutters 25 which open and close the carrier transfer inlet ports 24. When a shutter 25 is closed, the carrier transfer inlet port 24 is sealed airtight. Three electrode units 31 for forming films on the substrates W are attached to a second lateral surface 27 opposite to the first lateral surface 23. The electrode units 31 are attachable to and detachable from the film forming chamber 11. A vacuum pump 30 for evacuating the space within the film forming chamber 11 is connected to a third lateral surface lower portion 28 of the film forming chamber 11 via a vacuuming pipe 29 (refer to FIG. 3C; the illustration is omitted in FIGS. 3A and 3B).

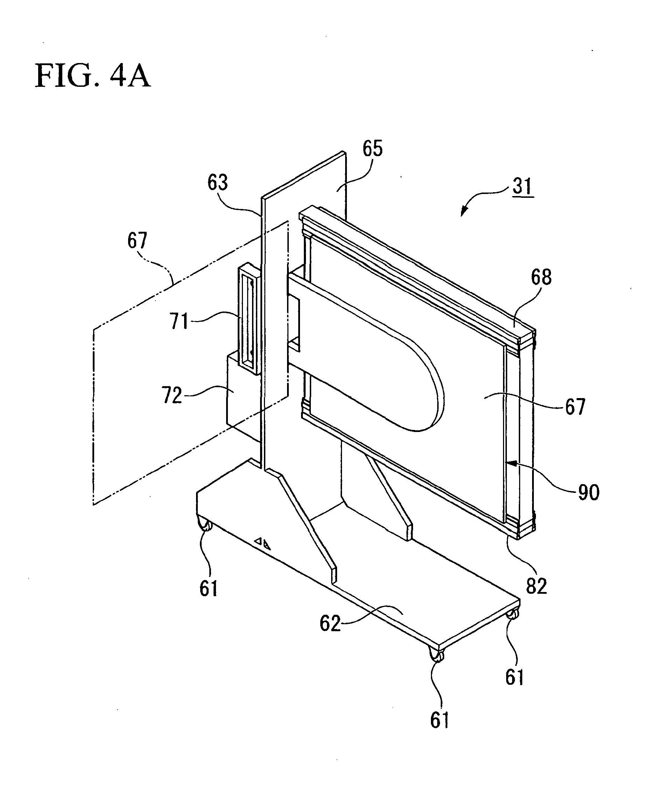

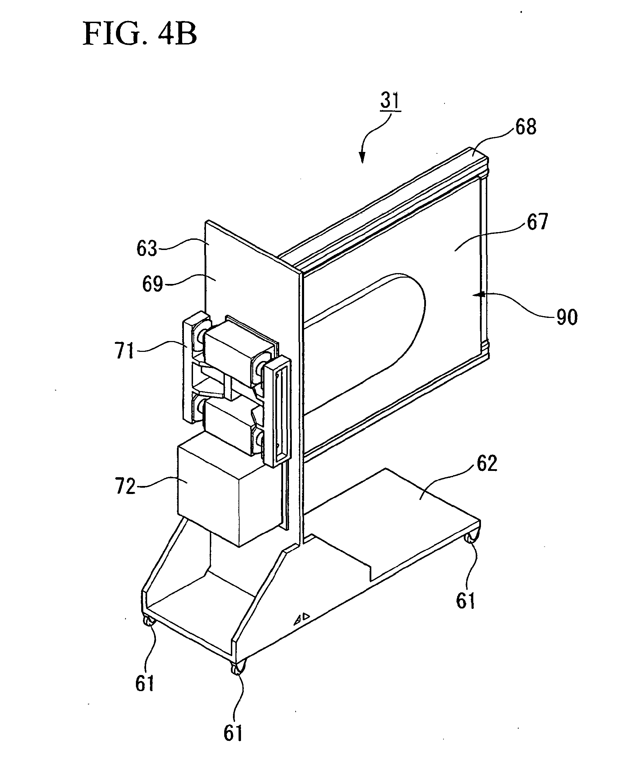

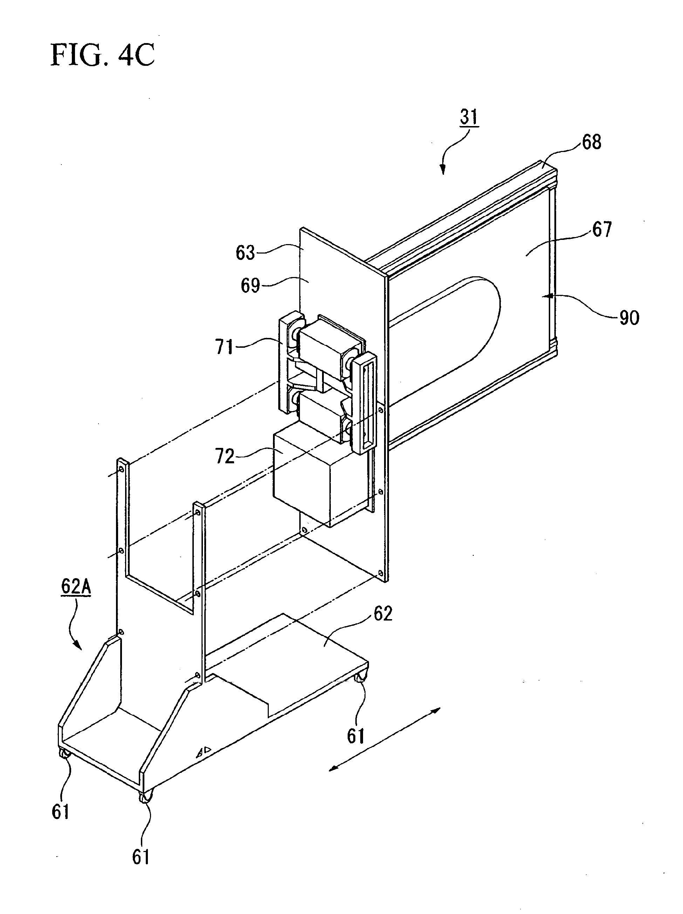

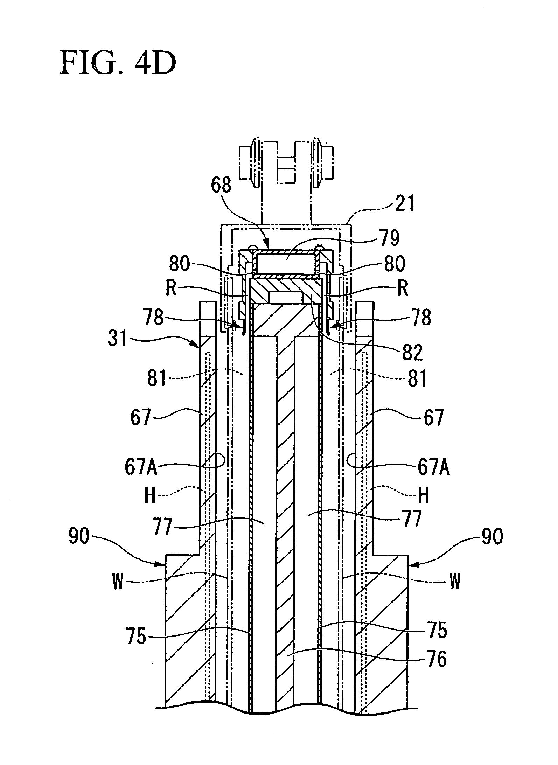

FIGS. 4A to 4D are schematic configuration views of the electrode unit 31. FIG 4A is a perspective view, FIG 4B is a perspective view as seen from an angle different from FIG 4A. FIG 4C is a perspective view showing a modification of the electrode unit 31. FIG 4D is a partial sectional view of a cathode unit and anodes (counter electrodes).

The electrode units 31 are attachable to and detachable from three openings 26 formed in the second lateral surface 27 of the film forming chamber 11 (refer to FIG 3B). Wheels 61 are provided at each of the four corners of the lower portion (bottom plate portion 62), and the electrode units 31 are movable on the floor surface. On a bottom plate portion 62 to which the wheels 61 are attached, a side plate portion 63 is erected along the vertical direction. The side plate portion 63 has a size such that the side plate portion 63 can block the opening 26 of the second lateral surface 27 of the film forming chamber 11.

As shown in the modification of FIG 4C, the bottom plate portion 62 with the wheels 61 may be a truck 62A which can be separated from and connected to the side plate portion 63 to which the cathode unit 68, the anode unit 90, and the like are attached. In this case, the truck 62A can be separated from the side plate portion 63 to which the cathode unit 31, the anode unit 90, and the like are attached after the electrode unit 68 is connected to the film forming chamber 11, and can be used for the transfer of other electrode units 31 as a common truck 62A.

The side plate portion 63 of the electrode unit 31 forms a part of a wall surface of the film forming chamber 11. One surface (surface which faces the inside of the film forming chamber 11) 65 of the side plate portion 63 is provided with anodes 67 and a cathode unit 68 which are arranged on both surfaces of the substrate W during film formation processing. The electrode unit 31 of the present embodiment includes a pair of anodes 67 arranged so as to be separated from each other with the cathode unit 68 therebetween. Films can be simultaneously formed on two substrates W by one electrode unit 31. Respective substrates W during film formation processing are arranged on both sides of the cathode unit 68, respectively, so as to face each other substantially parallel to the vertical direction. Two anodes 67 are arranged outside respective substrates W in its thickness direction in a state where the anodes face the substrates W, respectively.

A drive mechanism (drive part) 71 for driving the anodes 67, and a matching box 72 for feeding electric power to the cathode unit 68 when a film is formed are attached to the other surface 69 of the side plate portion 63. Moreover, the side plate portion 63 is formed with a connecting portion for piping (not shown) which supplies the film forming gas to the cathode unit 68.

Heaters H are built in two (a pair of) anodes 67 as temperature control sections for controlling the temperature of the substrate W. The two anodes 67 and the heaters H constitute the anode unit 90. Additionally, the two anodes 67 and 67 are movable in directions (horizontal directions) in which the anodes approach and separate from each other by the drive mechanism 71 provided at the side plate portion 63, and the separation distance between each substrate W and the cathode unit 68 can be controlled. Specifically, before films are formed on the substrates W, the two anodes 67 and 67 move toward the cathode unit 68, and comes into contact with the substrates W. Moreover, the two anodes 67 and 67 move in the directions in which the anodes 67 approach the cathode unit 68, and the separation distance between each substrate W and the cathode unit 68 is adjusted to a desired distance. Thereafter, films are formed, and after the end of film forming, the anodes 67 and 67 move in the directions in which the anodes 67 separate from each other, and the anodes 67 and the substrates W separate from each other, so that the substrates W can be easily taken out of the electrode unit 31.

Moreover, each anode 67 is attached to the drive mechanism 71 via a hinge (not shown). Thereby, the anode 67 can be turned so as to be opened and closed until the surface 67A of the anode 67 which faces the cathode unit 68 becomes substantially parallel to one surface 65 of the side plate portion 63, in a state which the electrode unit 31 is pulled out of the film forming chamber 11. That is, the anodes 67 are able to be turned by about 90° in plan view (refer to FIG 4A).

The cathode unit 68 has a shower plate (cathode) 75, a cathode intermediate member 76, a discharge duct 79, and a floating capacitance member 82.

A pair of shower plates 75 formed with a plurality of small holes (not shown) is arranged on the surfaces of the cathode unit 68 which face the anodes 67, respectively so that the film forming gas can be jetted toward the substrates W from the small holes. The shower plates 75 and 75 form cathodes (high-frequency electrode) electrically connected to the matching box 72. The cathode intermediate member 76 electrically connected to the matching box 72 is provided between the two shower plates 75 and 75. That is, the shower plates 75 are arranged on both sides of the cathode intermediate member 76 in a state where the shower plates 75 are electrically connected to the cathode intermediate member 76.

The cathode intermediate member 76 and each shower plate (cathode) 75 are formed from electrical conductors. High frequency wave is applied to the shower plate (cathode) 75 via the cathode intermediate member 76. For this reason, voltages to be applied to the two shower plates 75 and 75 for generating plasma have the same potential and phase.

The cathode intermediate member 76 is electrically connected to the matching box 72 by a wiring which is not shown. A space portion 77 is formed between the cathode intermediate member 76 and each shower plate 75. The film forming gas is introduced into the space portion 77 from a gas supply device (not shown). A pair of space portions 77 is separated from each other by the cathode intermediate member 76 interposed therebetween, and is individually formed so as to correspond to the shower plates 75 and 75, respectively. Therefore, the kinds or discharge amount of the gases discharged from the respective shower plates 75 and 75 can be independently controlled. That is, the space portion 77 has a role as a gas supply passage. In the present embodiment, the respective space portions 77 are separately formed so as to correspond to the shower plate 75 and 75, respectively. Thus, the cathode unit 68 has two types of gas supply passages.

A hollow discharge duct 79 is provided at a peripheral edge portion of the cathode unit 68 over the whole periphery thereof. The discharge duct 79 is formed with a vacuuming port 80 for introducing the film forming gas or reactive by-products (powder) within a film formation space 81 into the discharge duct 79, and evacuating the film forming gas or reactive by-products. Specifically, the vacuuming port 80 is formed so as to face the film formation space 81 formed between the substrate W and the shower plate 75 when a film is formed. A plurality of vacuuming ports 80 are formed along the peripheral edge portion of the cathode unit 68, and are configured so that evacuation can be made substantially equal over the whole periphery thereof.

The surface of the discharge duct 79 disposed at the lower portion of the cathode unit 68, which faces the film forming chamber 11, is formed with an opening α (not shown). The film forming gas discharged from the film formation space 81 is discharged into the film forming chamber 11 through the opening α. The gas discharged into the film forming chamber 11 is evacuated to the outside through the vacuuming pipe 29 provided at the lateral lower portion 28 of the film forming chamber 11 (refer to FIG 3C).

The floating capacitance member 82 which has a dielectric body and/or a laminating space of this dielectric body is provided between the discharge duct 79 and the cathode intermediate member 76.

The discharge duct 79 is connected to the ground potential. The discharge duct 79 also functions as a shield frame for preventing abnormal electrical discharge from the cathode 75 and the cathode intermediate member 76.

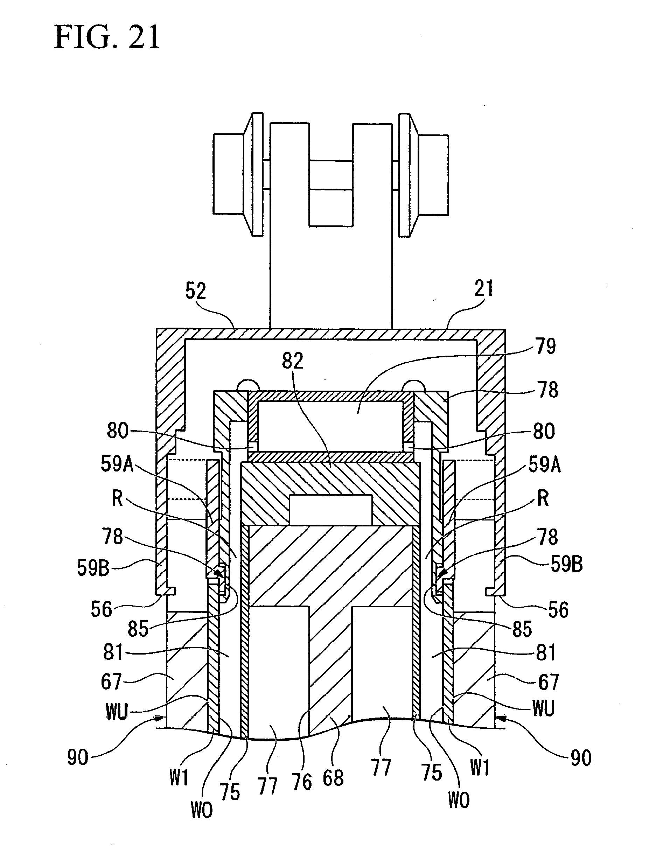

Moreover, a pair of masks 78 is provided at the peripheral edge portion of the cathode unit 68 so as to cover the part from the peripheral portion of the discharge duct 79 to the peripheral portion of the shower plate (cathode) 75. Each of the masks 78 covers a holding piece 59A (refer to FIGS. 9 and 21) of a holding portion 59 (which will be described later) provided at the carrier 21, and forms a gas flow passage R for guiding the film forming gas or reactive by-products (powder) within the film formation space 81 to the discharge duct 79. That is, the gas flow passage R is formed between the mask 78 and the shower plate 75, and between the mask 78 and the floating capacitance member 82.

A plurality of transfer rails 37 is laid between the film forming chamber 11 and the substrate replacement chamber 15 so that the carrier 21 can be transferred between the film forming chamber 11 and the loading-ejecting chamber 13, and between the loading-ejecting chamber 13 and the substrate replacement chamber 15 (refer to FIG 2). The transfer rails 37 are separated between the film forming chamber 11 and the loading-ejecting chamber 13, and the carrier transfer inlet ports 24 are sealed by closing the shutters 25.

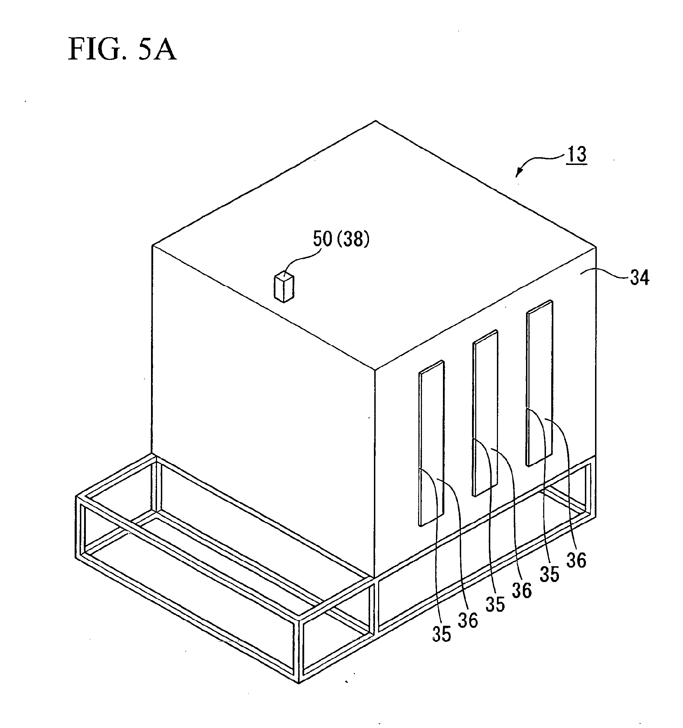

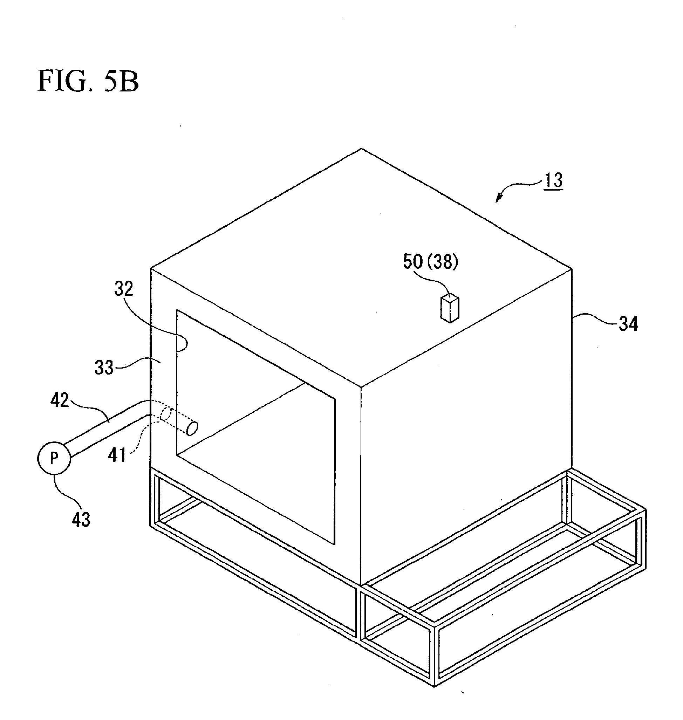

FIGS. 5A and 5B are schematic perspective views of the loading-ejecting chamber 13. FIG 5A is a perspective view, and FIG 5B is a perspective view as seen from an angle different from FIG 5A. As shown in FIGS. 5A and 5B, the loading-ejecting chamber 13 is formed in the shape of a box. A first lateral surface 33 is connected to the first lateral surface 23 of the film forming chamber 11 while securing airtightness. The first lateral surface 33 is formed with an opening 32 through which three carriers 21 can be inserted. A second lateral surface 34 which is opposite to the first lateral surface 33 is connected to the substrate replacement chamber 15. The second lateral surface 34 is formed with three carrier transfer inlet ports 35 which allow the carrier 21 on which the substrates W are mounted to pass therethrough. Each carrier transfer inlet port 35 is provided with a shutter 36 which can secure airtightness. The respective transfer rails 37 are separated between the loading-ejecting chamber 13 and the substrate replacement chamber 15, and the carrier transfer inlet ports 35 are sealed by closing the shutters 36.

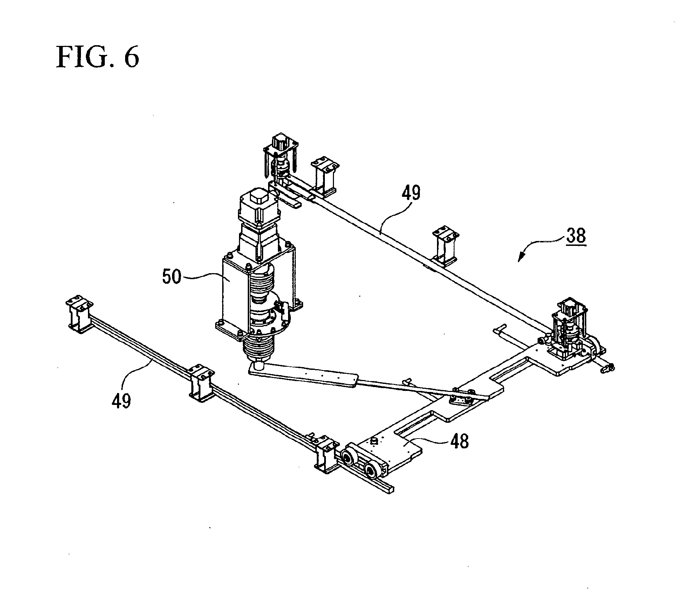

The loading-ejecting chamber 13 is provided with a push-pull mechanism 38 for transferring the carrier 21 between the film forming chamber 11 and the loading-ejecting chamber 13 along the transfer rails 37. As shown in FIG 6, the push-pull mechanism 38 includes: a locking portion 48 for locking the carrier 21; a pair of guide members 49 provided at both ends of the locking portion 48, and disposed substantially parallel to the transfer rails 37; and a transfer device 50 for moving the locking portion 48 along both the guide members 49.

Moreover, a transfer mechanism (not shown) for simultaneously storing the pre-processed substrate W1 and the post-processed substrate W2 is provided within the loading-ejecting chamber 13. The transfer mechanism transfers the carrier 21 by a predetermined distance in a direction substantially orthogonal to the direction in which the transfer rails 37 are laid in plan view.

A vacuum pump 43 for evacuating the inside of the loading-ejecting chamber 13 is connected to a third lateral surface lower portion 41 of the loading-ejecting chamber 13 via a vacuuming pipe 42 (refer to FIG 5B).

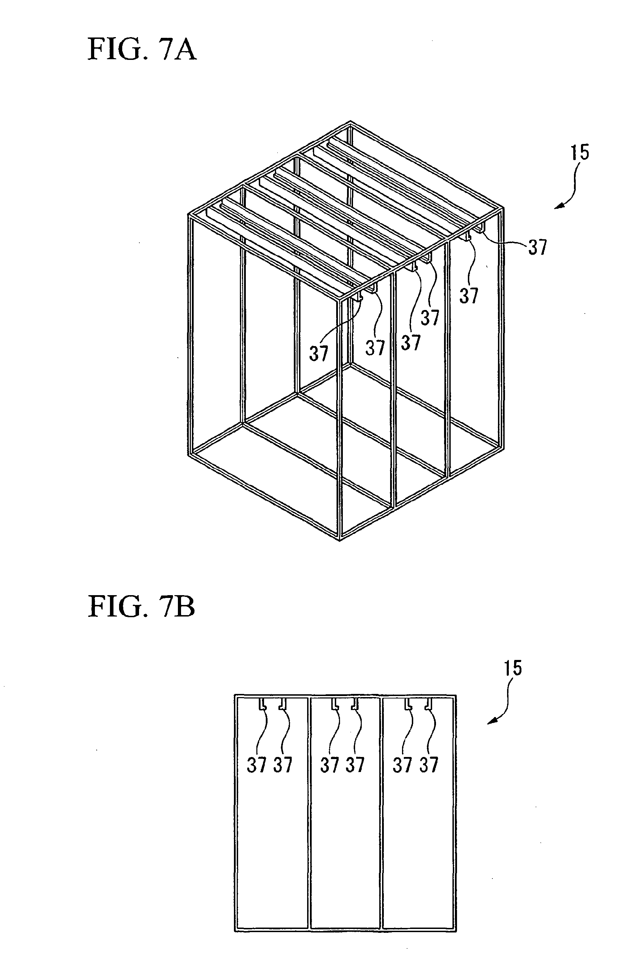

FIGS. 7A and 7B are schematic configuration views of the substrate replacement chamber. FIG 7A is a perspective view, and FIG 7B is a front view. As shown in FIGS. 7A and 7B, the substrate replacement chamber 15 is made of a frame-like body, and is connected to the second lateral surface 34 of the loading-ejecting chamber 13. In the substrate replacement chamber 15, attachment of the pre-processed substrates W1 and removal of the post-processed substrates W2 are performed with respect to the carrier 21 disposed at the transfer rails 37. Three carriers 21 can be arranged in parallel at the substrate replacement chamber 15.

As shown in FIG 2, the substrate replacement robot 17 has a drive arm 45. The drive arm 45 is adapted to be able to suction a substrate W with its tip. Additionally, the drive arm 45 moves between the carrier 21 disposed at the substrate replacement chamber 15, and the substrate storage holder 19 so that the pre-processed substrate W1 can be taken out of the substrate storage holder 19, and the pre-processed substrate W1 can be attached to the carrier 21 disposed at the substrate replacement chamber 15. Additionally, the drive arm 45 can remove the post-processed substrate W2 from the carrier 21 which has returned to the substrate replacement chamber 15, and can also convey the substrate W2 to the substrate storage holder 19.

FIG. 8 is a perspective view of the substrate storage holder 19. As shown in FIG 8, the substrate storage holder 19 is formed in the shape of a box, and has a size such that the holder can store a plurality of substrates W. A plurality of substrates W can be stacked and stored in the up-and-down direction within the substrate storage holder 19 in a state where the film-formation faces of the substrates are made horizontal. Additionally, casters 47 are provided at four corners of a lower portion of the substrate storage holder 19 so as to allow for easy movement to separate processing apparatuses.

FIG 9 is a perspective view of a carrier which conveys substrates W. As shown in FIG 9, the carrier 21 includes two frame-like frames 51 to which the substrates W can be attached. That is, two substrates W can be attached to one carrier 21. Two frames 51 and 51 are connected together by a connection member 52 at the upper portions thereof. A plurality of wheels 53 to be placed on the transfer rails 37 are provided on the top surface of the connection member 52. When the wheels 53 roll on the transfer rails 37, the carrier 21 is movable along the transfer rails 37. A lower portion of each frame 51 is provided with a frame holder 54 for suppressing the shaking of the substrate W when the carrier 21 is transferred. A lower end of the frame holder 54 is fitted into a rail member 55 with a concave cross-section provided on the bottom surface of each chamber. The rail members 55 are disposed along the transfer rails 37 in plan view. More stable conveyance becomes possible if the frame holder 54 is constituted of a plurality of rollers.

Each frame 51 has a peripheral edge portion 57 and a holding portion 59. The film formation face of the substrate W is exposed to an opening 56 formed in the frame 51. In the peripheral edge portion 57 of the opening 56, the holding portion 59 is adapted to hold and fix the substrate W from both sides thereof. A biasing force acts on the holding portion 59 which holds the substrate W by a spring or the like. Additionally, as shown in FIG 21, the holding portion 59 has holding pieces 59A and 59B which abut the front surface WO (film formation face) and rear surface WU (back surface) of the substrate W. The separation distance between the holding piece 59A and the holding pieces 59B is variable via the spring or the like. That is, the separation distance is variable along the directions in which the holding piece 59A approach and separates from the holding piece 59B according to the movement of the anode 67 (the details thereof will be described later). Here, one carrier 21 (one carrier 21 which can hold a pair of (two) substrates W) is attached onto one transfer rail 37. That is, three carriers (3 pairs of (six) substrates are held) 21 are attached to one substrate film formation line 16 constituted by a film forming chamber 11, a loading-ejecting chamber 13, and a substrate replacement chamber 15.

In the apparatus 10 for manufacturing a thin-film solar cell of the present embodiment, the above-described four substrate film formation lines 16 are arranged, and three carriers 21 are stored in one film forming chamber 11. Therefore, films can be substantially simultaneously formed on twenty four substrates W.

### (Method for Manufacturing Thin-film Solar Cell)

Next, a method for forming a film on a substrate W using the apparatus 10 for manufacturing a thin-film solar cell of the present embodiment will be described. Although one substrate film formation line 16 is depicted in this description, the other three substrate film formation lines 16 form films on substrates W according to almost the same flow.

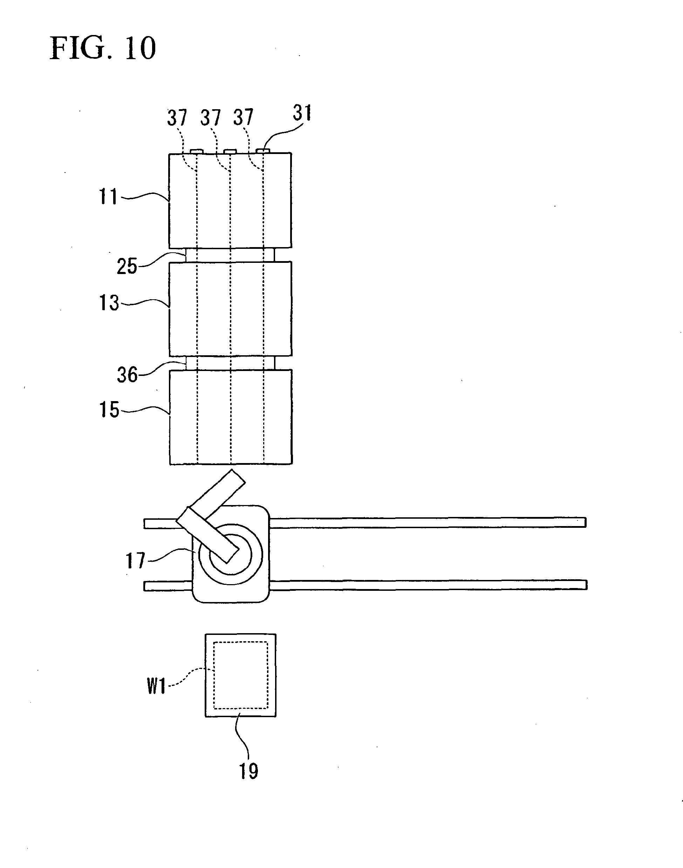

First, as shown in FIG 10, the substrate storage holder 19 which stores a plurality of pre-processed substrates W1 is arranged at a predetermined position.

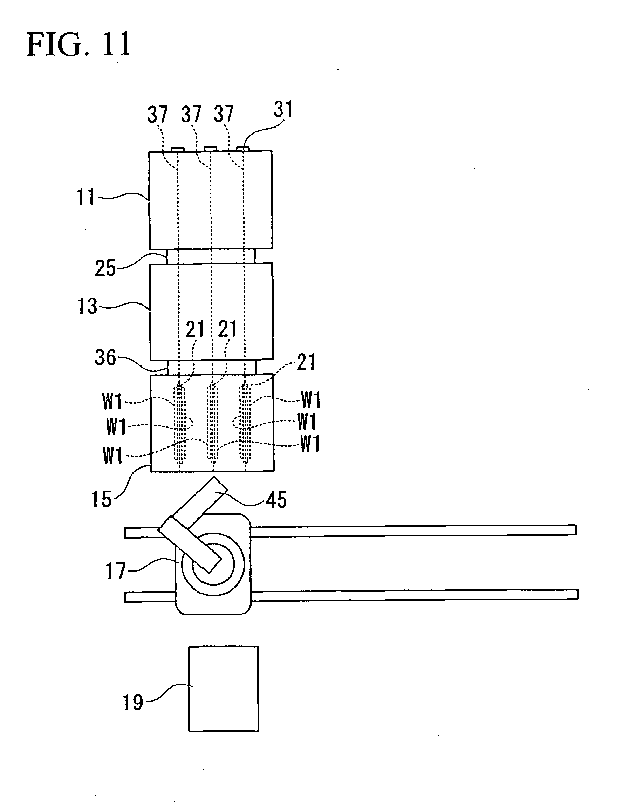

Subsequently, as shown in FIG 11, the drive arm 45 of the substrate replacement robot 17 is operated to take one pre-processed substrate W1 out of the substrate storage holder 19, and attaches the substrate W1 to a carrier 21 within the substrate replacement chamber 15. At this time, the pre-processed substrate W1 which has been arranged in the horizontal direction in the substrate storage holder 19 is attached to the carrier 21 after its orientation is changed to the vertical direction. This operation is repeated once again to attach two pre-processed substrates W1 to one carrier 21.

Moreover, this operation is repeated to attach the pre-processed substrates W1 even to the remaining two carriers 21 within the substrate replacement chamber 15, respectively. That is, six pre-processed substrates W1 are attached in this process.

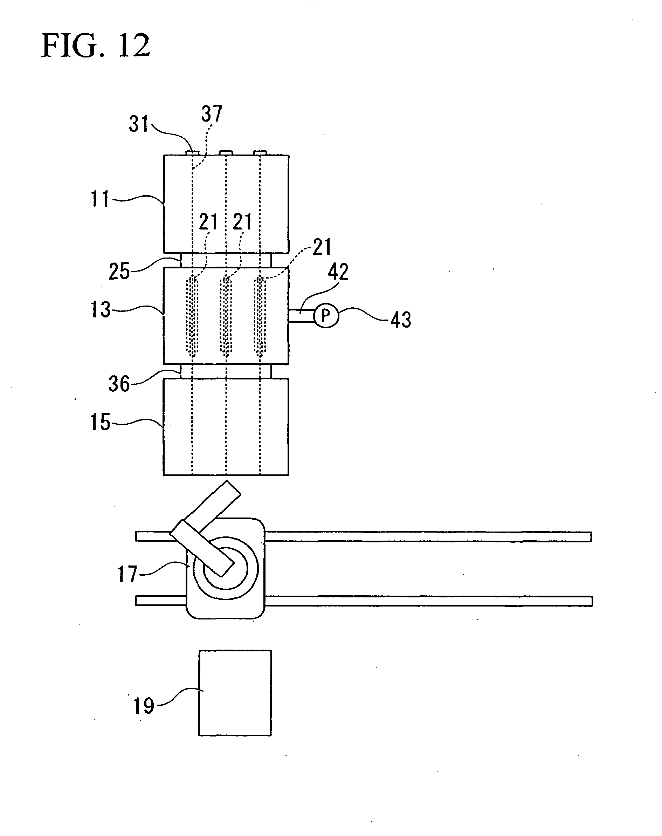

Subsequently, as shown in FIG 12, the three carriers 21 to which the pre-processed substrates W1 are attached are substantially simultaneously transferred along the respective transfer rails 37, and are stored within the loading-ejecting chamber 13. After the carriers 21 are stored within the loading-ejecting chamber 13, the shutters 36 of the carrier transfer inlet ports 35 of the loading-ejecting chamber 13 are closed. Thereafter, the inside of the loading-ejecting chamber 13 is held in a vacuum state using the vacuum pump 43.

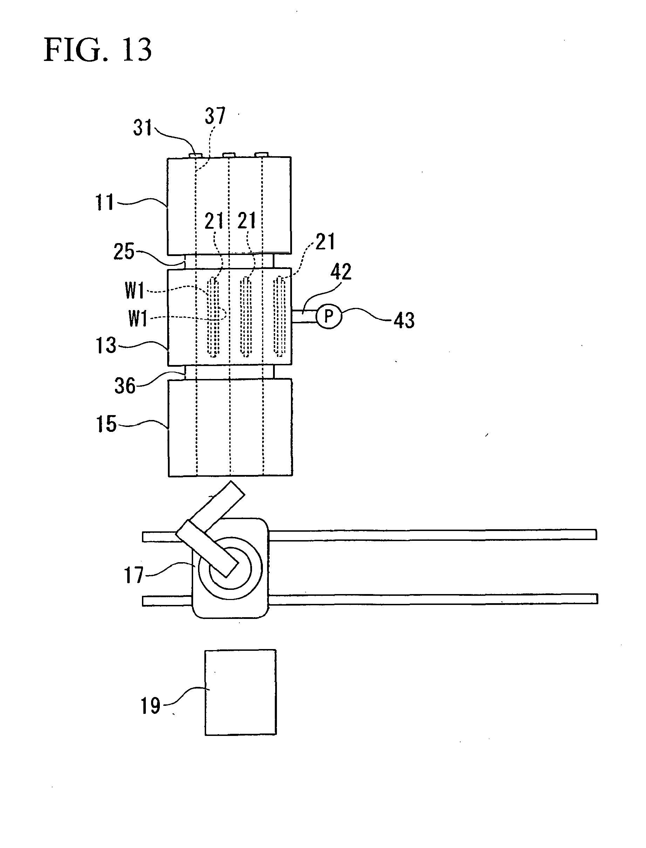

Subsequently, as shown in FIG 13, the three carriers 21 are respectively transferred by a predetermined distance using the transfer mechanism, in a direction orthogonal to a direction in which the respective transfer rails 37 are laid in plan view.

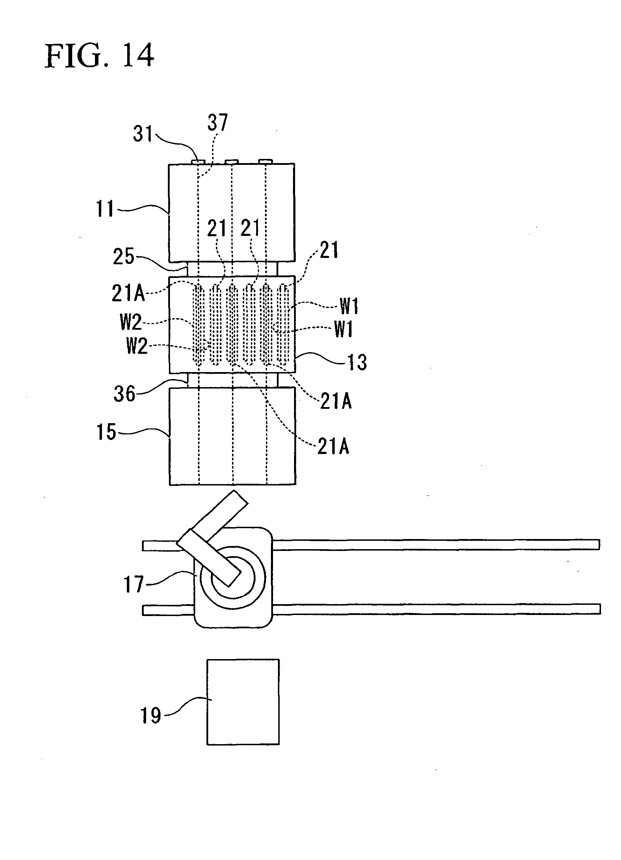

Subsequently, as shown in FIG 14, the shutters 25 of the film forming chamber 11 are brought into an opened state, and the carriers 21A to which the post-processed substrates W2 of which the film forming has been ended in the film forming chamber 11 are attached are transferred to the loading-ejecting chamber 13, using the push-pull mechanism 38. At this time, the carrier 21 holding the pre-processed substrates W1 and the carrier 21 A holding the post-processed substrates W2 are alternately arranged in parallel in plan view. By maintaining this state for a predetermined time, the heat which is accumulated in the post-processed substrates W2 is transferred to the pre-processed substrates W1. That is, the pre-processed substrates W1 are heated.

Here, the operation of the push-pull mechanism 38 will be described. Herein, the operation when the carriers 21 A within the film forming chamber 11 are transferred into the loading-ejecting chamber 13 will be described.

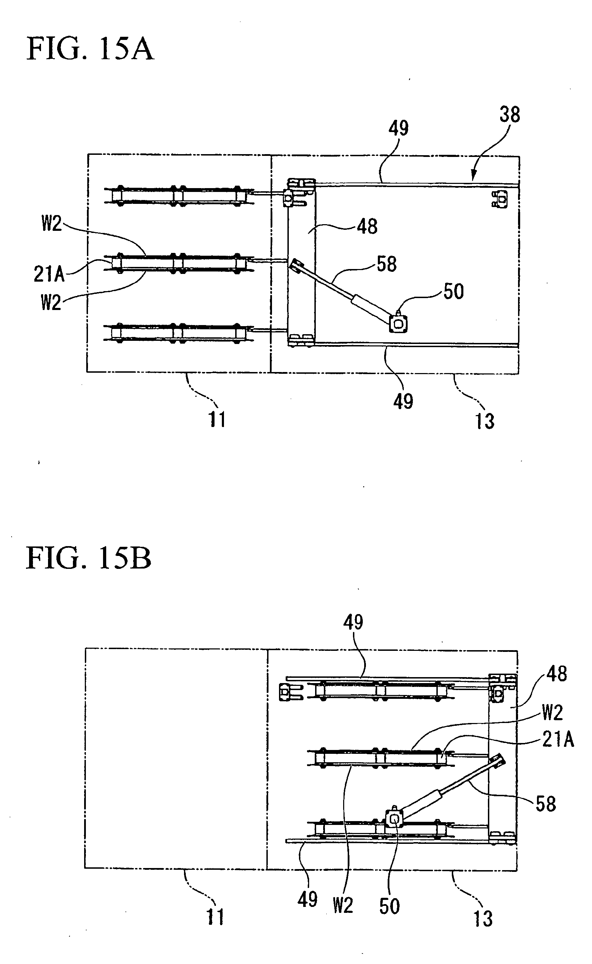

As shown in FIG 15A, the carriers 21A to which the post-processed substrates W2 is attached are locked to the locking portion 48 of the push-pull mechanism 38. Then, the transfer arm 58 of the transfer device 50 attached to the locking portion 48 is swung. At this time, the length of the transfer arm 58 is variable. Then, the locking portion 48 to which the carriers 21 A have been locked moves while being guided by the guide members 49, and as shown in FIG 15B, the carrier 21A moves into the loading-ejecting chamber 13 from the film forming chamber 11. By adopting such a configuration, it becomes unnecessary to provide a drive source for driving the carriers 21 A within the film forming chamber 11.

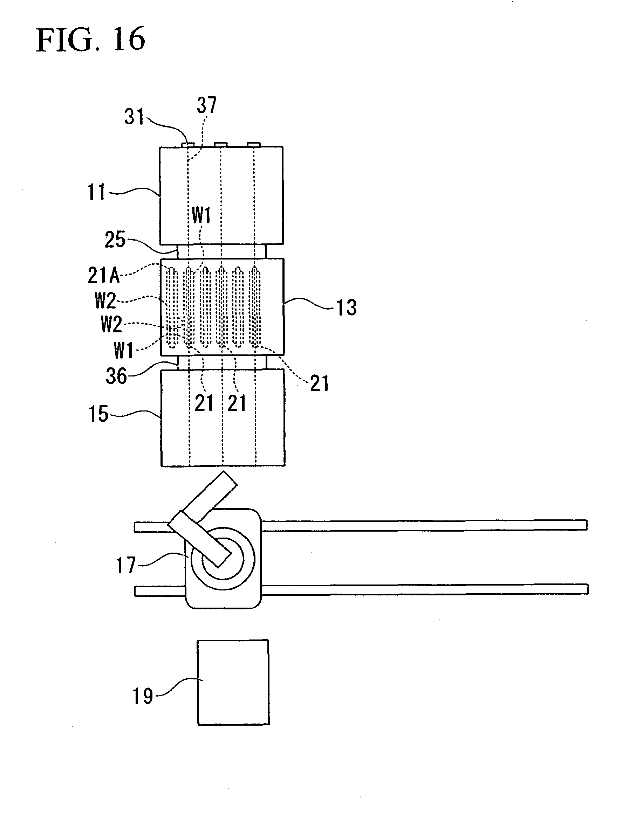

Subsequently, as shown in FIG 16, the carriers 21 and the carriers 21A are transferred in a direction orthogonal to the transfer rails 37 by the transfer mechanism, and the respective carriers 21 holding the pre-processed substrates W1 are transferred to the positions of the respective transfer rails 37.

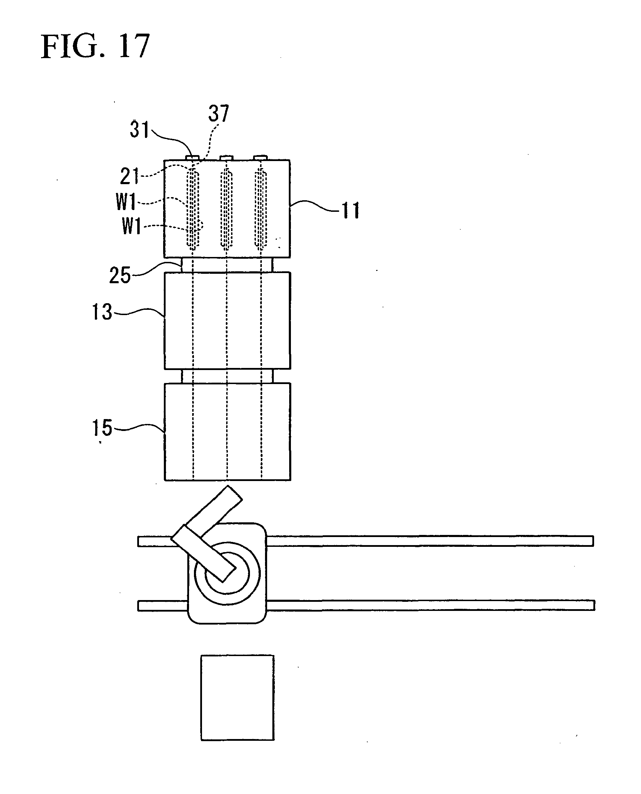

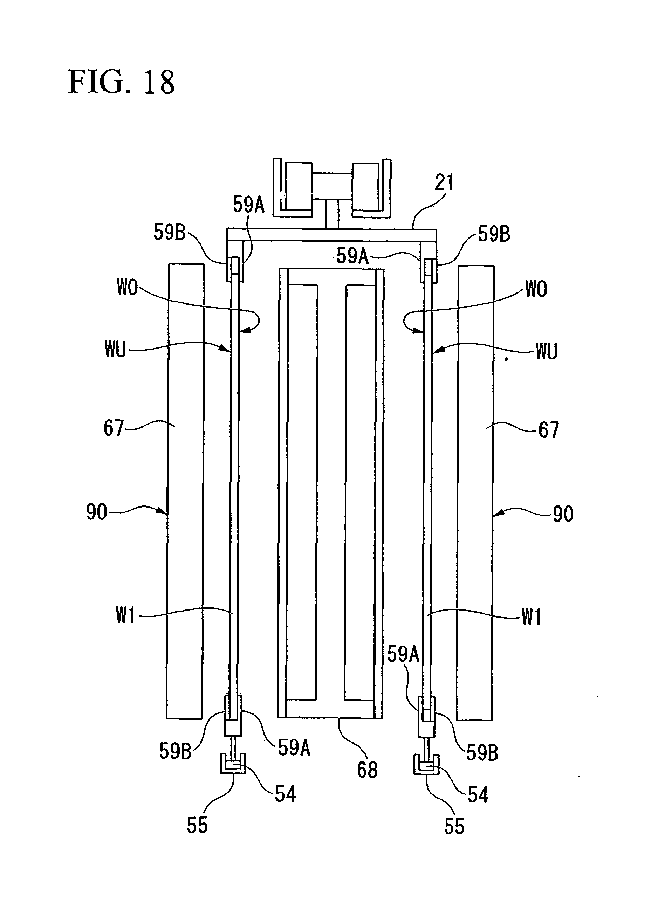

Subsequently, as shown in FIG 17, the respective carriers 21 holding the pre-processed substrates W1 are transferred into the film forming chamber 11, using the push-pull mechanism 38, and the shutters 25 are closed after the completion of transfer. The vacuum state is maintained within the film forming chamber 11. At this time, the pre-processed substrates W1 attached to each carrier 21 moves along the planar direction thereof, and are inserted between the anodes 67 and the cathode unit 68 within the film forming chamber 11 so that the front surfaces WO of the pre-processed substrates W1 become substantially parallel to the vertical direction (refer to FIG 18).

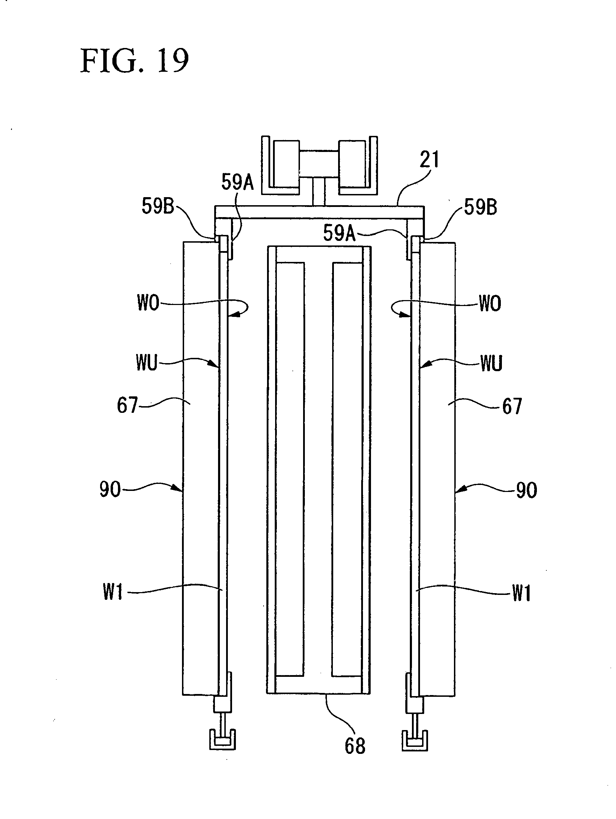

Subsequently, as shown in FIGS. 18 and 19, the anodes 67 are made to come into contact with the rear surfaces WU of the pre-processed substrates W1 by moving the two anodes 67 in directions in which the anodes approach each other by the drive mechanism 71.

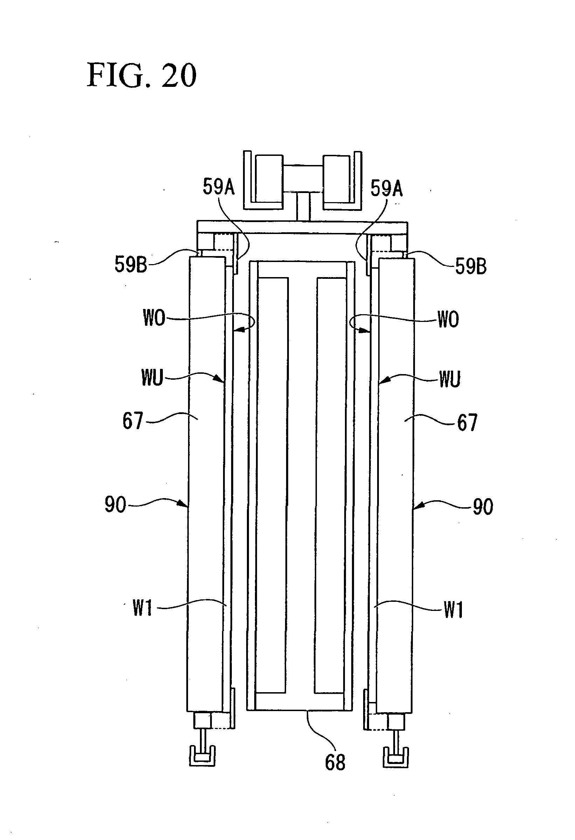

As shown in FIG 20, when the drive mechanism 71 is further driven, the pre-processed substrates W1 move toward the cathode unit 68 so as to be pushed by the anodes 67. Moreover, the pre-processed substrates W1 are moved until the gap between the pre-processed substrate W1 and the shower plate 75 of the cathode unit 68 reaches a predetermined distance (film forming distance). The gap (film forming distance) between the substrate W1 before this film formation processing and the shower plate 75 of the cathode unit 68 is within a range of 5 mm to 15 mm, and is preferably set to, for example, about 5 mm.

At this time, the holding piece 59A of the holding portion 59 of the carrier 21 which abuts the front surface WO of the pre-processed substrate W1 is displaced in a direction away from the holding piece 59B with the movement (movement of the anode 67) of the pre-processed substrate W1. At this time, the pre-processed substrate W1 is held between the anode 67 and the holding piece 59A. When the anode 67 has moved toward the direction away from the cathode unit 68, since the restoring force of the spring which is not shown acts on the holding piece 59A, the holding piece 59A is displaced toward the holding piece 59B.

When the pre-processed substrate W1 moves toward the cathode unit 68, the holding piece 59A comes into contact with the mask 78, and the movement of the anode 67 stops at this time (refer to FIG. 21).

As shown in FIG 21, the mask 78 is formed so as to cover the surface of the holding piece 59A and the outer-edge portion of the substrate W and come into close contact with the holding piece 59A or the outer-edge portion of the substrate W. That is, a mating surface between the mask 78 and the holding piece 59A or the outer-edge portion of the substrate W has a role of a sealing surface. Therefore, the film forming gas scarcely leaks out toward the anode 67 from between the mask 78 and the holding piece 59A or the outer-edge portion of the substrate W. This limits the range where the film forming gas spreads, and can prevent formation of a film to an unnecessary range, that is, the anode 67 or the outer-edge portion of the substrate W. Moreover, since the mask 78 can be separated from the film forming chamber 11 integrally with the electrode unit 31, cleaning of the mask 89 becomes easier. As a result, the operating rate of the apparatus 10 for manufacturing a thin-film solar cell improves.

The movement of the pre-processed substrate W1 stops when the outer-edge portion of the substrate abuts the mask 78. Therefore, the gap between the mask 78 and the shower plate 75 and the gap of the mask 78 and the discharge duct 79, that is, the flow passage dimension of the gas flow passage R in the thickness direction is set so that the gap between the pre-processed substrate W1 and the cathode unit 68 reaches a predetermined distance.

As another form, the distance between the substrate W and the shower plate (cathode) 75 can also be arbitrarily changed by the stroke of the drive mechanism 71 by attaching the mask 78 to the discharge duct 79 via an elastic body. In the above embodiment, the mask 78 and the substrate W come into contact with each other. However, the mask 78 and the substrate W may be arranged so as to leave a minute gap which limits the passage of the film forming gas.

Subsequently, the film forming gas is jetted from the shower plate 75 of the cathode unit 68, and the matching box 72 is started to apply a voltage to the cathode 76 of the cathode unit 68. This generates plasma in the film formation space 81, thereby forming a film on the front surface WO of the pre-processed substrate W1. At this time, the pre-processed substrate W1 is heated to a desired temperature by the heater H (for example, a heating wire or the like) built in the anode 67.

The anode 67 stops heating when the pre-processed substrate W1 reaches a desired temperature. However, when plasma is generated in the film formation space 81 by applying a voltage to the shower plate (cathode) 75, even if the heating of the anode 67 is stopped, there is a possibility that the temperature of the pre-processed substrate W1 may rise higher than the desired temperature due to the heat input from the plasma with the passage of time. In this case, the anode 67 can also be made to function as a radiator plate for cooling the pre-processed substrate W1 where the temperature has risen excessively. Accordingly, the temperature of the pre-processed substrate W1 is adjusted to a desired temperature irrespective of the passage of the film formation processing time.

When a plurality of layers is film-formed through one film formation processing process, this film formation can be carried out by switching a film forming gas material to be supplied every predetermined time.

During film forming and after film forming, the gas or reactive by-products (powder) in the film formation space 81 flows into the discharge duct 79 from the vacuuming ports 80 formed in the peripheral edge portion of the cathode unit 68 via the gas flow passage R. The gas which has flowed into the discharge duct 79 passes through the opening α of the discharge duct 79 arranged at the lower portion of the cathode unit 68, and is evacuated to the outside from the vacuuming pipe 29 provided at the lateral lower portion 28 of the film forming chamber 11. Meanwhile, the reactive by-products (powder) generated when a film is formed can be collected and disposed of when being deposited on and adhered to the inner wall surface of the discharge duct 79.

Since the same processing as the above-described processing is performed in all the electrode units 31 within the film forming chamber 11, film formation processing can be simultaneously performed on all six substrates.

When the film formation processing is ended, the two anodes 67 are moved in directions away from each other by the drive mechanism 71, and the post-processed substrates W2 and the frames 51 (holding pieces 59A) are returned to their original positions (refer to FIG 19). That is, when the film formation is ended and the carrier 21 is transferred, the masks 78 are removed through the exposure surfaces 85 of the holding pieces 59A.

Moreover, by moving the anodes 67 in directions away from each other, the post-processed substrates W2 and the anodes 67 are separated from each other (refer to FIG. 18).

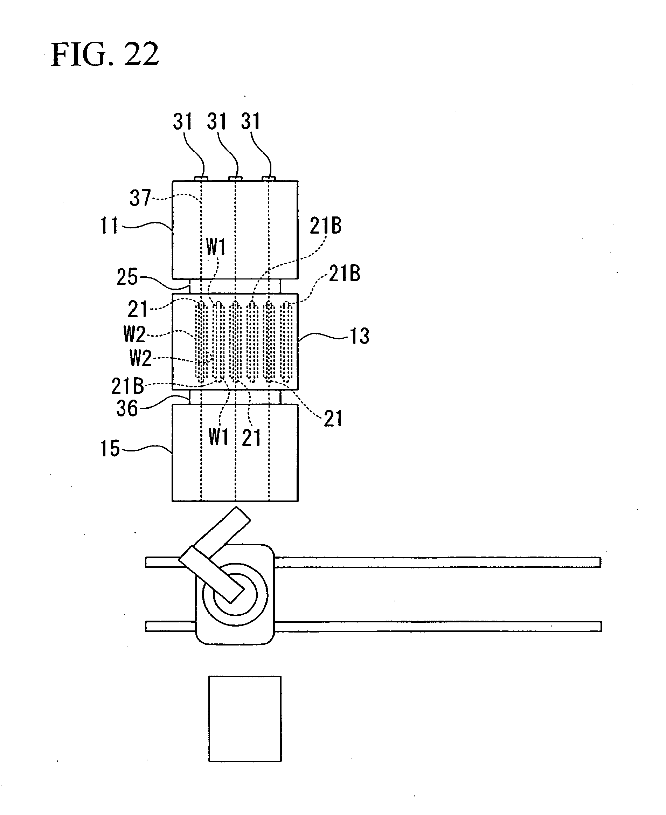

Subsequently, as shown in FIG 22, the shutters 25 of the film forming chamber 11 are opened, and each carrier 21 is transferred into the loading-ejecting chamber 13, using the push-pull mechanism 38. At this time, the inside of the loading-ejecting chamber 13 is evacuated, and the carriers 21B to which the pre-processed substrates W1 to be film-formed next are already arranged. Then, the heat accumulated in the post-processed substrates W2 is transferred to the pre-processed substrates W1 within the loading-ejecting chamber 13, and the temperature of the post-processed substrates W2 is lowered.

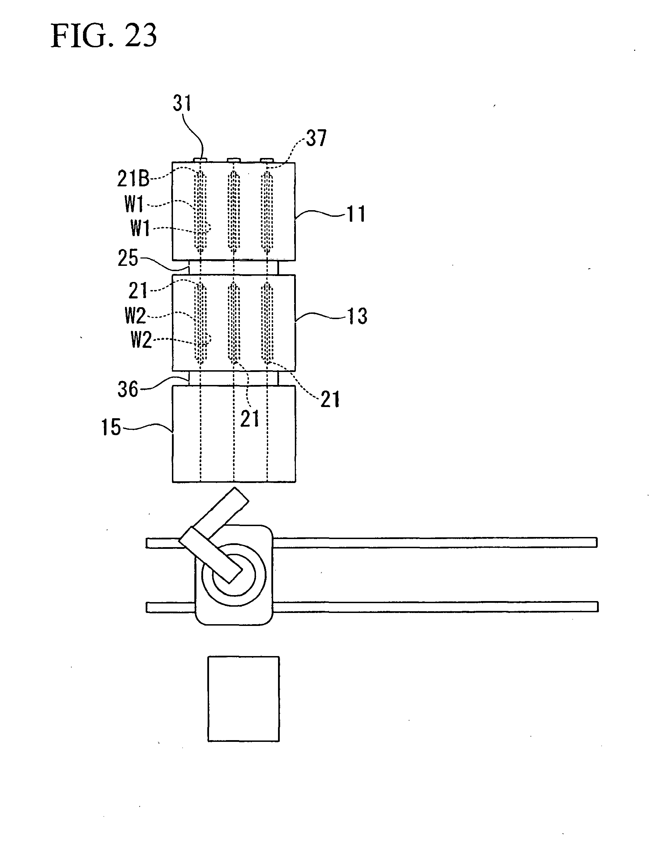

Subsequently, as shown in FIG 23, after each carrier 21B is transferred into the film forming chamber 11, each carrier 21 is returned to the position of the transfer rails 37 by the transfer mechanism.

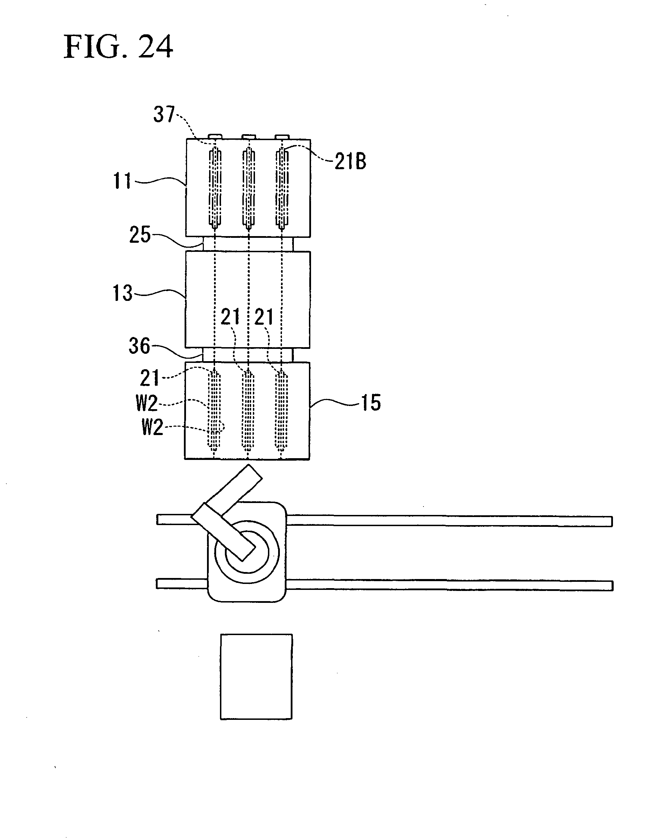

Subsequently, as shown in FIG 24, after the shutters 25 are closed, the inside of the loading-ejecting chamber 13 is brought to an atmospheric pressure, the shutters 36 are opened, and each carrier 21 is transferred into the substrate replacement chamber 15.

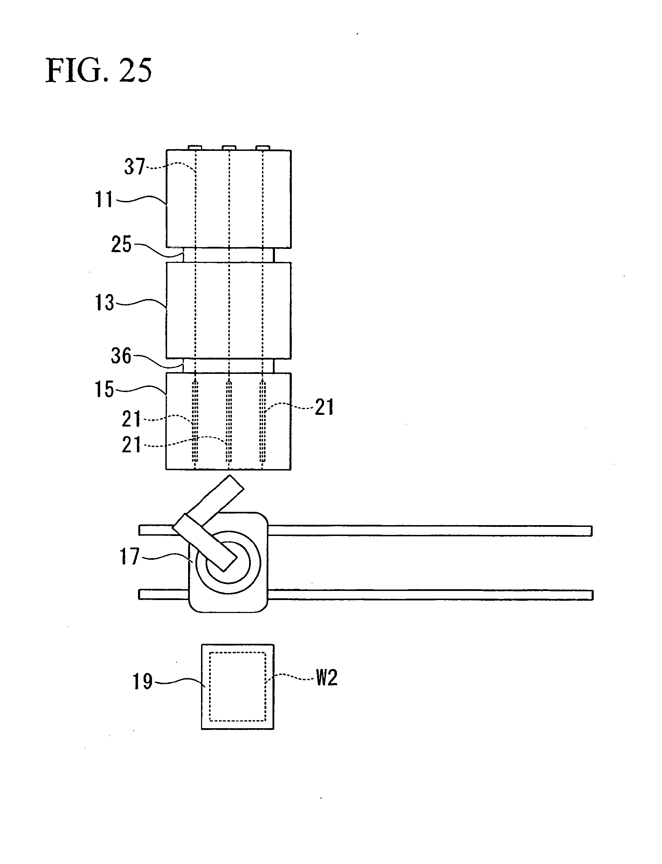

Subsequently, as shown in FIG 25, each post-processed substrate W2 is removed from each carrier 21 by the substrate replacement robot 17 within the substrate replacement chamber 15, and is transferred to the substrate storage holder 19. When removal of all the post-processed substrates W2 is completed, the film formation processing is ended by moving the substrate storage holder 19 to a place for the following process.

Therefore, according to the above-described embodiment, the anodes 67 move along the directions in which the anodes 67 approach and separate from the cathode (shower plate 75), the gap between the anodes 67 and the cathode (shower plate 75) can be set widely when the substrate W enters and exits the film forming chamber 11. Meanwhile, when a thin-film Si-layer is film-formed on the substrate W by the plasma-CVD method, the gap between the pre-processed substrate W1 and the shower plate 75 of the cathode unit 68 can be set small so as to reach a predetermined distance (film forming distance). Specifically, this predetermined distance can be set to about 5 mm. For this reason, it is possible to facilitate entrance and exit of the substrate W from the inside of the film forming chamber 11 while improving the quality of film forming, and it is possible to improve productivity. Additionally, when the substrate W enters and exits the film forming chamber, it is possible to prevent the substrate W from contacting and being damaged by the anode 67 or the cathode unit 68.

Moreover, the cathode unit 68 which is comparatively difficult to move is disposed between two substrates W, that is, substantially at the center of the inside of the film forming chamber 11. Meanwhile, the anodes 67 which are comparatively easy to move are disposed outside two substrates W, that is, at the inner lateral surface of the film forming chamber 11. The separation distance between the substrate W and the cathode unit 68 is controlled by making the anode 67 movable by the drive mechanism 71. For this reason, as compared to a case where the cathode unit 68 is moved, complication of the apparatus 10 for manufacturing a thin-film solar cell can be suppressed, and the manufacturing costs of the apparatus 10 for manufacturing a thin-film solar cell can be reduced.

Additionally, when a film is formed, two anodes 67 of the electrode unit 31 are moved in the directions in which the anodes 67 approach each other by the drive mechanism 71, and each anode 67 and the rear surface WU of the pre-processed substrate W1 are made to abut each other. Moreover, the pre-processed substrate W1 is moved toward the cathode unit 68 so to be pushed by the anode 67 by driving the drive mechanism 71. The heater H is built in the anode 67, and the anode 67 and the heater H constitutes the anode unit 90. For this reason, since nothing is interposed between the anode 67 and the substrate W when a film is formed, the substrate W can be efficiently heated. Additionally, if a substrate W gets too warm with prolonged film forming work, the anode 67 can be used as a heat dissipation medium of the substrate W. Hence, irrespective with the passage of film formation processing time, it is possible to keep the substrate W constant at a desired temperature, and higher-quality film formation can be performed.

Also, a hollow discharge duct 79 is provided at a peripheral edge portion of the cathode unit 68 over the whole periphery thereof. This enables the film forming gas (exhaust gas) to be evacuated from the whole periphery of the substrate W. For this reason, it is possible to improve evacuation efficiency.

Additionally, for example, reactive by-products (powder) or the like generated when a film is formed can be easily collected by performing evacuation using the discharge duct 79. The reactive by-products (powder) can be collected and disposed of when being made to adhere to the inner wall surface of the discharge duct 79. For this reason, it is possible to bring the film forming gas evacuated to the outside from the vacuuming pipe 29 provided at the lateral lower portion 28 of the film forming chamber 11 to a comparatively clean state where reactive by-products (powder) are not included.

Also, the holding portion 59 provided at the carrier 21 has holding piece 59A which abuts the front surface WO, and holding piece 59B which abuts the rear surface WU of the substrate W. The separation distance between the holding pieces 59A and 59B is variable via the spring or the like, that is, the holding piece 59A is configured to be movable along the directions in which the holding piece 59A approaches and separates from the holding piece 59B according to the movement of the anode 67. For this reason, with the movement of the anode 67, the substrate W can be easily approached or separated from the cathode unit 68.

Additionally, the shower plates 75 and 75 are the cathodes (high-frequency electrode) connected to the matching box 72. Therefore, it becomes unnecessary to separately provide the cathodes and the shower plates 75. As a result, it is possible to achieve simplification and lower cost of the apparatus 10 for manufacturing a thin-film solar cell.

Moreover, the cathode unit 68 has a shower plate (cathode) 75, a cathode intermediate member 76, a discharge duct 79, and a floating capacitance member 82. A pair of shower plates 75 is arranged on both sides of the cathode intermediate member 76 in a state where the shower plates 75 are electrically connected to the cathode intermediate member 76. Also, the cathode intermediate member 76 and the shower plates (cathodes) 75 are formed from electrical conductors, and high frequency wave is applied to the respective shower plates (cathodes) 75 via the cathode intermediate member 76. For this reason, voltages of the same potential and phase for generating plasma are applied to the pair of shower plates 75 and 75.

For this reason, it is possible to apply voltages of the same potential and phase without separately controlling the pair of shower plates (cathodes) 75 and 75. As a result, the configuration of a voltage control device or the like can be simplified, and lower cost of the apparatus 10 for manufacturing a thin-film solar cell can be achieved.

The space portions (gas supply passages) 77 are separated from each other by the cathode intermediate member 76, and are individually formed so as to correspond to the shower plates 75 and 75, respectively. Therefore, the gases discharged from the respective shower plates 75 and 75 can be independently controlled. For this reason, the film forming gases discharged from the respective shower plates 75 are independently controlled according to the status of use of the apparatus 10 for manufacturing a thin-film solar cell, so that a difference can be prevented from appearing in the quality of films on the respective substrates W. Additionally, it is also possible to form different films on the respective substrates W arranged on both sides of the cathode unit 68, and the variation of the film forming method can be increased.

It should be understood that the technical scope of the present invention is not limited to the above-described embodiments, but that various modifications of the above-described embodiments may be made without departing from the scope of the invention. That is, the specific shapes and configurations as set mentioned in the embodiments are merely examples, and can be appropriately changed.

### Description of the Reference Symbols

- 10:: APPARATUS FOR MANUFACTURING THIN-FILM SOLAR CELL
- 11:: FILM FORMING CHAMBER
- 21:: CARRIER (CONVEYING PART)
- 59:: HOLDING PORTION
- 59A:: HOLDING PIECE (FIRST HOLDING PIECE)
- 59B:: HOLDING PIECE (SECOND HOLDING PIECE)
- 67:: ANODE
- 68:: CATHODE UNIT
- 71:: DRIVE MECHANISM (DRIVE PART)
- 75:: CATHODE ALSO SERVING AS SHOWER PLATE
- 76:: CATHODE INTERMEDIATE MEMBER
- 77:: SPACE PORTION (GAS SUPPLY PASSAGE)
- 79:: DISCHARGE DUCT
- 80:: VACUUMING PORT
- 81:: FILM FORMATION SPACE
- 82:: FLOATING CAPACITANCE MEMBER
- H:: HEATER (TEMPERATURE CONTROL SECTION)
- R:: GAS FLOW PASSAGE
- W:: SUBSTRATE
- W1:: PRE-PROCESSED SUBSTRATE
- W2:: POST-PROCESSED SUBSTRATE
- WO:: SURFACE (FILM FORMATION FACE)
- WU:: BACK SURFACE (REAR SURFACE)

## Claims

1. An apparatus for manufacturing a thin film solar cell comprising:
a film forming chamber in which a substrate is arranged so that the film formation face of the substrate is substantially parallel to the direction of gravitational force and a film is formed on the film formation face using a CVD method;
an electrode unit including a cathode unit having shower plates to which voltages are to be applied arranged on both sides thereof, and a pair of anodes each of which is arranged to face a different one of the shower plates, at a separation distance therefrom; and
a conveying part which supports the substrate and conveys the substrate to between the cathode unit and the anode facing the cathode unit, wherein:
the electrode unit further includes a drive part which moves the anode in directions which make the anode approach or separate from the cathode unit; and the separation distance between the shower plate and the anode is variable.

2. The apparatus for manufacturing a thin-film solar cell according to Claim 1, wherein
the separation distance between the film formation face of the substrate and the shower plates is controlled as the anode moves while abutting the substrate when the anode approaches the shower plates.

3. The apparatus for manufacturing a thin-film solar cell according to Claim 1, wherein
the cathode unit further includes two gas supply passages, and
each of the gas supply passages is connected to the corresponding shower plates, and the flow rate or kind of the film forming gas discharged from one of the shower plates is controlled independently from the other cathode.

4. The apparatus for manufacturing a thin-film solar cell according to Claim 1, wherein
a discharge duct through which the film forming gas is evacuated is arranged on the outer peripheral surface of the cathode unit.

5. The apparatus for manufacturing a thin-film solar cell according to Claim 3, wherein:
the conveying part has a first holding piece which abuts the film formation face of the substrate, and a second holding piece which abuts the back surface of the substrate;
the substrate is held by the first holding piece and the second holding piece;
when the anode approaches the cathode unit, the first holding piece separates from the second holding piece; and
when the anode separates from the cathode unit, the first holding piece approaches the second holding piece.

6. The apparatus for manufacturing a thin-film solar cell according to Claim 1, wherein
a temperature control section for controlling the temperature of the substrate is built in the anode.

## Patentansprüche

1. Vorrichtung zum Herstellen einer Dünnfilm-Solarzelle, umfassend:
eine Filmbildungskammer, in der ein Substrat so angeordnet ist, dass die Filmbildungsfläche des Substrates im Wesentlichen parallel zu der Richtung der Erdanziehungskraft ist, und ein Film auf der Filmbildungsfläche unter Verwendung eines CVD-Verfahrens gebildet wird;
eine Elektrodeneinheit, die eine Kathodeneinheit beinhaltet, welche an beiden Seiten derselben angeordnete Brauseplatten, an die Spannungen anzulegen sind, aufweist, und ein Paar von Anoden, von denen jede so angeordnet ist, dass sie einer anderen der Brauseplatten gegenübersteht, in einem Trennabstand davon; und
ein Überführungsteil, welches das Substrat stützt und das Substrat zwischen die Kathodeneinheit und die Anode, die der Kathodeneinheit gegenübersteht, hin überführt, wobei:
die Elektrodeneinheit des Weiteren ein Antriebsteil beinhaltet, welches die Anode in Richtungen bewegt, die bewirken, dass die Anode sich der Kathodeneinheit nähert oder sich von dieser entfernt; und wobei der Trennabstand zwischen der Brauseplatte und der Anode variabel ist.

2. Vorrichtung zum Herstellen einer Dünnfilm-Solarzelle nach Anspruch 1, wobei
der Trennabstand zwischen der Filmbildungsfläche des Substrates und den Brauseplatten konstrolliert wird, wenn sich die Anode bewegt während sie an dem Substrat anliegt, wenn sich die Anode den Brauseplatten nähert.

3. Vorrichtung zum Herstellen einer Dünnfilm-Solarzelle nach Anspruch 1, wobei
die Kathodeneinheit des Weiteren zwei Gasbereitstellungsdurchgänge beinhaltet, und
jeder der Gasbereitstellungsdurchgänge mit den korrespondierenden Brauseplatten verbunden ist, und die Flussrate oder die Art des Filmbildungsgases, das von einer der Brauseplatten abgegeben wird, unabhängig von der anderen Kathode kontrolliert wird.

4. Vorrichtung zum Herstellen einer Dünnfilm-Solarzelle nach Anspruch 1, wobei
ein Abgabekanal, durch den das Filmbildungsgas evakuiert wird, an der äußeren Randfläche der Kathodeneinheit angeordnet ist.

5. Vorrichtung zum Herstellen einer Dünnfilm-Solarzelle nach Anspruch 3, wobei:
das Überführungsteil ein erstes Haltestück aufweist, das an der Filmbildungsfläche des Substrats anliegt, und ein zweites Haltestück, das an der Rückseite des Substrats anliegt;
das Substrat durch das erste Haltestück und das zweite Haltestück gehalten wird;
wenn die Anode sich der Kathodeneinheit nähert, das erste Haltestück sich von dem zweiten Haltestück entfernt; und
wenn die Anode sich von der Kathodeneinheit entfernt, das erste Haltestück sich dem zweiten Haltestück nähert.

6. Vorrichtung zum Herstellen einer Dünnfilm-Solarzelle nach Anspruch 1, wobei
ein Temperatursteuerabschnitt zum Steuern der Temperatur des Substrates in die Anode eingebaut ist.

## Revendications

1. Dispositif de fabrication d'une photopile à couche mince comprenant :
une chambre de formation d'une couche mince, dans lequel un substrat est disposé de manière à ce que la face de formation d'une couche mince du substrat soit sensiblement parallèle à la direction de la force de gravité et une couche mince est formée sur la face de formation d'une couche mince, en utilisant un procédé CVD ;
une unité d'électrode, comprenant une unité de cathode ayant des plaques d'aspersion, auxquelles des tensions doivent être appliquées, disposées sur ses deux côtés et une paire d'anodes, chacune d'elles étant disposée de manière à être en face de l'une différente des plaques d'aspersion, à une distance de séparation de celles-ci et
une partie de convoyage, qui supporte le substrat et transporte le substrat entre l'unité de cathode et l'anode en face de l'unité de cathode, dans lequel :
l'unité d'électrode comprend, en outre, une partie d'entraînement, qui déplace l'anode dans des directions qui font que l'anode se rapproche ou se sépare de l'unité de cathode et la distance de séparation entre la plaque d'aspersion et l'anode est variable.

2. Dispositif de fabrication d'une photopile à couche mince suivant la revendication 1, dans lequel
la distance de séparation, entre la face de formation d'une couche mince du substrat et les plaques d'aspersion, est réglée au fur et à mesure que l'anode se déplace, tout en mettant le substrat en butée lorsque l'anode se rapproche des plaques d'aspersion.

3. Dispositif de fabrication d'une photopile à couche mince suivant la revendication 1, dans lequel
l'unité de cathode comprend en outre deux passages d'alimentation en gaz et
chacun des passages d'alimentation en gaz communique avec les plaques d'aspersion correspondantes et le débit ou la nature du gaz de formation d'une couche mince, sortant de l'une des plaques d'aspersion, est réglé indépendamment de l'autre cathode.

4. Dispositif de fabrication d'une photopile à couche mince suivant la revendication 1, dans lequel
un conduit d'évacuation, par lequel le gaz formant une couche mince est évacué, est disposé sur la surface périphérique extérieure de l'unité de cathode.

5. Dispositif de fabrication d'une photopile à couche mince suivant la revendication 3, dans lequel
la partie de convoyage a une première pièce de maintien, qui vient en butée sur la face de formation d'une couche mince du substrat et une deuxième pièce de maintien, qui vient en butée sur la face arrière du substrat ;
le substrat est maintenu par la première pièce de maintien et par la deuxième pièce de maintien ;
lorsque l'anode se rapproche de l'unité de cathode, la première pièce de maintien se sépare de la deuxième pièce de maintien et,
lorsque l'anode se sépare de l'unité de cathode, la première pièce de maintien se rapproche de la deuxième pièce de maintien.

6. Dispositif de fabrication d'une photopile à couche mince suivant la revendication 1, dans lequel
une section de commande de la température, pour commander la température du substrat, est constituée dans l'anode.
